# EUROPEAN PATENT APPLICATION

(11) **EP 4 462 960 A1**
(43) Date of publication of application: **13.11.2024**
(21) Application number: 23735161.4
(22) Date of filing: 03.01.2023
(51) Int. Cl.: H05K 1/18, H05K 1/11, H05K 3/46, H01L 23/12

(54) **CIRCUIT BOARD**

(30) Priority: 03.01.2022 KR 20220000591
(71) Applicant: LG INNOTEK CO., LTD., Seoul 07796 (KR)
(72) Inventor: KIM, Eom Ji, Seoul 07796 (KR); JEONG, Jae Hun, Seoul 07796 (KR); LEE, Soo Min, Seoul 07796 (KR)
(74) Representative: Plasseraud IP
(86) International application number: PCT/KR2023/000071
(87) International publication number: WO 2023/128729

(57) **Abstract**

A circuit board according to an embodiment comprises a first insulating layer; a first pattern layer disposed on an upper surface of the first insulating layer; a second insulating layer disposed on the upper surface of the first insulating layer and including a cavity; and a barrier layer disposed on a first pattern layer vertically overlapping with the cavity among the first pattern layers, wherein the upper surface of the first insulating layer includes: a first upper surface vertically overlapping a lower surface of the cavity, and a second upper surface that does not vertically overlap the lower surface of the cavity, wherein the first pattern layer includes: a first pattern part disposed on the first upper surface of the first insulating layer, and a second pattern part disposed on the second upper surface of the first insulating layer, wherein an upper surface of the first pattern part is exposed through the cavity without contacting the first and second insulating layers, and wherein the barrier layer is disposed on the upper surface of the first pattern part.

## Description

### [Technical Field]

An embodiment relates to a circuit board and a semiconductor package comprising the same.

### [Background Art]

Recently, efforts have been made to develop improved 5G (5th generation) communication systems or pre-5G communication systems to meet the demand for wireless data traffic.

The 5G communication system uses ultra-high frequency (mm-Wave) bands (sub 6 GHz, 28 GHz, 38 GHz or higher frequencies) to achieve high data transfer rates. This high frequency band is called mm-Wave due to the length of the wavelength.

In order to alleviate the path loss of radio waves in the ultra-high frequency band and increase the transmission distance of radio waves, integration technologies such as beamforming, massive MIMO, and array antenna are being developed in 5G communication systems.

Considering that these frequency bands can consist of hundreds of active antennas of wavelengths, antenna systems can be relatively large.

This means that a plurality of boards that make up an active antenna system, that is, an antenna board, an antenna feed board, a transceiver board, a and baseband board, must be integrated into one compact unit.

Accordingly, the circuit board applied to the conventional 5G communication system has a structure in which a number of substrates are integrated, and thus has a relatively thick thickness.

Meanwhile, in order to reduce the thickness of the circuit board in the prior art, a cavity is formed in the circuit board, and various component elements are disposed in the formed cavity. In this case, the circuit board includes a pad on which the various component elements are mounted. In addition, the pad has a structure in which a surface is exposed through the cavity.

However, in the case of a pad exposed through the cavity, there is a problem in that the pad exposed through the cavity is continuously exposed in subsequent processes to provide damage (e.g., chemical damage). In addition, due to the damage above, the pad has a thickness thinner than a target thickness or a deformation of its shape occurs, resulting in a physical or electrical reliability problem.

In addition, conventionally, the thickness of the pad is set to compensate for the change in the thickness of the pad. For example, when a final thickness targeted by the pad is 10 µm, an initial thickness of the pad is formed to be about 15 µm to 20 µm in consideration of the chemical damage. However, when the thickness of the pad increases, there is a limit to the miniaturization of the circuit pattern layer including the pad, and accordingly, there is a problem that an overall volume of the circuit board increases.

Accordingly, the circuit board and the semiconductor package with a new structure are required.

### [Disclosure]

### [Technical Problem]

An embodiment provides a circuit board having a new structure and a semiconductor package including the same.

In addition, the embodiment provides a circuit board that can prevent damage to the pad that occurs during a laser process forming a cavity and a semiconductor package including the same.

In addition, the embodiment provides a circuit board capable of refining a pad exposed through a cavity and a semiconductor package including the same.

In addition, the embodiment provides a circuit board capable of preventing damage to the pad that occurs in subsequent processes after cavity formation and a package substrate including the same.

Technical problems to be solved by the proposed embodiments are not limited to the above-mentioned technical problems, and other technical problems not mentioned may be clearly understood by those skilled in the art to which the embodiments proposed from the following descriptions belong.

### [Technical Solution]

A circuit board according to an embodiment comprises a first insulating layer; a first pattern layer disposed on an upper surface of the first insulating layer; a second insulating layer disposed on the upper surface of the first insulating layer and including a cavity; and a barrier layer disposed on a first pattern layer vertically overlapping with the cavity among the first pattern layers, wherein the upper surface of the first insulating layer includes: a first upper surface vertically overlapping a lower surface of the cavity, and a second upper surface that does not vertically overlap the lower surface of the cavity, wherein the first pattern layer includes: a first pattern part disposed on the first upper surface of the first insulating layer, and a second pattern part disposed on the second upper surface of the first insulating layer, wherein an upper surface of the first pattern part is exposed through the cavity without contacting the first and second insulating layers, and wherein the barrier layer is disposed on the upper surface of the first pattern part.

In addition, the first upper surface of the first insulating layer constitutes the lower surface of the cavity, and the second upper surface of the first insulating layer has a step difference from the first upper surface, a thickness of the first pattern part is smaller than a thickness of the second pattern part, and at least a portion of a side surface of the first pattern part is covered with the first insulating layer.

In addition, the side surface of the first pattern part is entirely covered with the first insulating layer, and the barrier layer includes a first portion disposed on an upper surface of the first pattern part, and a second portion extending from the first portion and disposed on the first upper surface of the first insulating layer.

In addition, a thickness of the first pattern part is smaller than a thickness of the second pattern part, an upper surface of the first pattern part is positioned lower than an upper surface of the second pattern part, and a lower surface of the first pattern part is positioned on the same plane as a lower surface of the second pattern part.

In addition, the first pattern layer includes a third pattern part disposed on a boundary region between the first upper surface and the second upper surface of the first insulating layer, and a thickness of the third pattern part is smaller than a thickness of the second pattern part.

In addition, an upper surface of the first pattern part is not in contact with the second insulating layer, upper surfaces of the second and third pattern parts are in contact with the second insulating layer, the upper surface of the third pattern part is positioned higher than the upper surface of the first pattern part, and is positioned on the same plane as the upper surface of the second pattern part, and a lower surface of the third pattern part is positioned higher than a lower surface of the second pattern part and is equal to or higher than the upper surface of the first pattern part.

In addition, the second pattern part includes a first metal layer horizontally overlapping the first pattern part; and a second metal layer disposed on the first metal layer and in contact with the second upper surface of the first insulating layer, a thickness of the first metal layer of the second pattern part corresponds to a thickness of the first pattern part, and a thickness of the second metal layer of the second pattern part corresponds to a thickness of the third pattern part.

In addition, the first upper surface of the first insulating layer is positioned lower than the second upper surface, an upper surface of the second pattern part, and an upper surface of the third pattern part.

In addition, the first upper surface of the first insulating layer is positioned lower than an upper surface of the first pattern part, a side surface of the first pattern part includes: a first side surface covered by the first insulating layer, and a second side surface exposed through the cavity without being covered by the first insulating layer, the barrier layer includes: a first portion disposed on an upper surface of the first pattern part, and a second portion disposed on the second side surface of the first pattern part.

In addition, the first upper surface of the first insulating layer is positioned higher than an upper surface of the first pattern part, the first insulating layer includes a recess portion formed by a step between the first upper surface and the upper surface of the first pattern part, and the barrier layer is disposed in the recess portion.

In addition, the first pattern part protrudes on the first upper surface of the first insulating layer, a side surface of the first pattern part includes a first side surface covered with the second insulating layer, and a second side surface exposed through the cavity without being covered with the second insulating layer, and the barrier layer includes a first portion disposed on an upper surface of the first pattern part and a second portion disposed on the second side surface of the first pattern part.

In addition, the first pattern part protrudes on the first upper surface of the first insulating layer, and a side surface of the first pattern part is entirely exposed through the cavity without contacting the first insulating layer and the second insulating layer, and the barrier layer includes a first portion disposed on an upper surface of the first pattern part and a second portion disposed on a side surface of the first pattern part.

In addition, the barrier layer is disposed on the first pattern part with a plurality of layer structures.

In addition, the barrier layer includes a first layer disposed on the first pattern part and including nickel, a second layer disposed on the first layer and including palladium, and a third layer disposed on the second layer and including gold.

Meanwhile, a semiconductor package according to an embodiment includes a first insulating layer; a second insulating layer disposed on one surface of the first insulating layer and including a cavity; a first pattern layer including disposed between the first insulating layer and the second insulating layer and including a first pattern part disposed in a first region vertically overlapping with the cavity, a second pattern part disposed in a second region that does not vertically overlap the cavity, and a third pattern part disposed in a boundary region between the first and second regions; a second pattern layer disposed on an other surface of the first insulating layer; a third pattern layer disposed on an upper surface of the second insulating layer; a barrier layer disposed on the first pattern part of the first pattern layer; a connection part disposed on the barrier layer; and a device mounted on the connection part, wherein an upper surface of the first pattern part is positioned lower than upper surfaces of the second and third pattern parts, an upper surface of the second pattern part is positioned on the same plane as an upper surface of the third pattern part, a lower surface of the third pattern part is positioned higher than lower surfaces of the first and second pattern parts, and a lower surface of the first pattern part is positioned on the same plane as a lower surface of the second pattern part.

### [Advantageous Effects]

According to the above-described embodiment, the circuit board includes the first pattern part of which the upper surface is exposed through the cavity. In addition, a barrier layer is disposed on the first pattern part. The barrier layer may be composed of a plurality of layers. For example, the barrier layer may include first to third layers. The barrier layer may function to protect the first pattern part in a subsequent process after the cavity is formed. Accordingly, the embodiment does not need to increase a thickness of the first pattern part in consideration of the change in a thickness of the first pattern part occurring in the subsequent process. Accordingly, the embodiment may miniaturize the first pattern part. Furthermore, the embodiment may reduce the manufacturing cost by reducing the thickness of the first pattern part. In addition, the embodiment may prevent a change in a shape of the first pattern part occurring in the subsequent process. Accordingly, the embodiment may allow the chip to be stably mounted on the first pattern part. Accordingly, the embodiment may improve the physical and electrical reliability of the circuit board.

In addition, the circuit board of the embodiment includes a first substrate layer and a second substrate layer. The second substrate layer may include a cavity. The first substrate layer includes a first-first insulating layer disposed closest to the first substrate layer and a first pattern layer disposed on an upper surface of the first-first insulating layer. The first pattern layer includes a first pattern part disposed in a first region vertically overlapping the cavity, a second pattern part disposed in a second region that does not vertically overlap the cavity, and a third pattern part disposed in a boundary region between the first and second regions. A thickness of at least one of the first to third pattern parts is different from a thickness of at least another of the first to third pattern parts. In addition, upper or lower surfaces of at least one of the first to third pattern parts may be positioned on a plane different from upper or lower surfaces of at least another of the first to third pattern parts. The embodiment may allow the first pattern layer disposed in the region adjacent to the cavity to have a structure in which different thicknesses or surfaces are disposed at different positions, thereby improving process characteristics of a process of forming the cavity. Accordingly, the embodiment may solve a reliability problem that may occur during a process of forming a cavity.

Specifically, the embodiment allows the first pattern layer to have a two-layer structure including a first metal layer and a second metal layer through two-stage plating in the process of forming the first pattern layer. At this time, the first pattern part, which is a mounting pad, is formed using one of the first metal layer and the second metal layer, a third pattern part, which is a laser stopper, is formed using the other one of the first metal layer and the second metal layer, and a second pattern part is formed using both the first metal layer and the second metal layer. Accordingly, the embodiment may solve the reliability problem that occurs when the mounting pad and the stopper are disposed on the same plane. For example, in a comparative example, a separate protective layer (not shown) is formed on the mounting pad to prevent damage to the mounting pad in a laser process of forming the cavity, and then a process of removing the separate protective layer is performed. In contrast, the embodiment may utilize a part of the third pattern part used as the laser stopper as a protection part of the first pattern part, which is the mounting pad, as the protection part. Accordingly, it is possible to omit a process of forming an additional protective layer for protecting the first pattern part while preventing the first pattern part, which is the mounting pad, from being damaged in the process of forming the cavity.

In addition, the first substrate layer includes a first region vertically overlapping the cavity and a second region excluding the first region. In addition, the second substrate layer includes a third region corresponding to the cavity and a fourth region excluding the third region. In this case, the third region of the second substrate layer of the embodiment is a region in which a driving device is disposed, and the fourth region is a region in which an antenna pattern layer is disposed. In the above embodiment, an antenna pattern layer is placed in the fourth region of the second substrate layer adjacent to a driving device in a horizontal direction while mounting the driving device using the cavity of the second substrate layer. Accordingly, in an embodiment, a signal transmission distance between the antenna pattern layer and the driving device may be minimized, and thus signal transmission loss may be minimized. For example, the embodiment can reduce the signal transmission distance and reduce the signal transmission loss caused by a separate connection method compared to connecting a substrate where the driving device is disposed and a substrate where the antenna pattern layer is disposed using a separate connection method. In addition, the embodiment may have a structure in which the antenna pattern layer and the driving device are disposed in a horizontal direction, and accordingly, the embodiment may utilize the second region of the first substrate layer, which vertically overlaps the fourth region of the second substrate layer, as a second antenna pattern layer. Accordingly, it is possible to enable antenna pattern radiation and signal reception in different directions using one circuit pattern.

In addition, the embodiment may mount a driving device in the cavity of the second substrate layer, thereby reducing an overall thickness of the circuit board to correspond to a depth of the cavity.

In addition, a cavity of the embodiment includes a first portion having a first slope and a second portion having a second slope different from the first slope. In this case, the second slope has an inclination angle smaller than the first slope with respect to a lower surface of the cavity. In addition, a vertical length of the second portion having the second slope of the embodiment is longer than a vertical length of the first portion having the first slope. Accordingly, the embodiment may reduce a space occupied by the cavity compared to the comparative example, thereby improving circuit integration. For example, the embodiment can increase a length of the antenna pattern layer in a substrate having the same size as the comparative example by reducing the space occupied by the cavity, thereby improving communication performance.

In addition, the embodiment may allow the thickness of the through electrode to have the same thickness as or less than that of the circuit layer. Accordingly, an embodiment may allow the thickness of the through electrode to have the same thickness as that of the circuit layer or less than that of the circuit layer, and accordingly, the thickness of the circuit board may be reduced. In addition, an embodiment may reduce a signal transmission distance in a signal transmission path including the through electrode by reducing the thickness of the through electrode, thereby minimizing the signal transmission loss.

In addition, the embodiment can increase the number of layers of the circuit layer by reducing the thickness of the insulating layer and the through electrode in a structure of the circuit board having the same thickness as the comparative example, thereby improving circuit integration and communication performance.

### [Description of Drawings]

FIG. 1 is a view illustrating a circuit board according to an embodiment.
FIG. 2 is an enlarged view of a cavity region of FIG. 1.
FIG. 3A is an enlarged view of an arrangement region of a first pattern layer of a circuit board according to a first embodiment.
FIG. 3B is an enlarged view of an arrangement region of a first pattern layer of a circuit board according to a second embodiment.
FIG. 3C is an enlarged view of an arrangement region of a first pattern layer of a circuit board according to a third embodiment.
FIGS. 4A and 4B are top plan views of the second substrate layer.
FIG. 5A is a view illustrating a circuit board according to a first modified example.
FIG. 5B is a view illustrating a circuit board according to a second modified example.
FIG. 5C is a view illustrating a circuit board according to a third modified example.
FIG. 6 is a view illustrating a circuit board according to a second embodiment.
FIG. 7 is an enlarged view of a partial region of FIG. 6.
FIG. 8 is a view illustrating a circuit board according to a third embodiment.
FIG. 9 is a view illustrating a circuit board according to a fourth embodiment.
FIG. 10 is a view illustrating a semiconductor package according to an embodiment.
FIGS. 11A to 11P are views showing a method of manufacturing a circuit board according to an embodiment shown in FIG. 1 in order of processes.

### [Modes of the Invention]

Hereinafter, embodiments of the present invention will be described in detail with reference to the accompanying drawings.

However, the spirit and scope of the present invention is not limited to a part of the embodiments described, and may be implemented in various other forms, and within the spirit and scope of the present invention, one or more of the elements of the embodiments may be selectively combined and redisposed.

In addition, unless expressly otherwise defined and described, the terms used in the embodiments of the present invention (including technical and scientific terms may be construed the same meaning as commonly understood by one of ordinary skill in the art to which this invention belongs, and the terms such as those defined in commonly used dictionaries may be interpreted as having a meaning that is consistent with their meaning in the context of the relevant art.

Further, the terms used in the embodiments of the present invention are for describing the embodiments and are not intended to limit the present invention. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present invention, the terms such as first, second, A, B, (a), and (b) may be used. These terms are only used to distinguish the elements from other elements, and the terms are not limited to the essence, order, or order of the elements. In addition, when an element is described as being "connected", "coupled", or "contacted" to another element, it may include not only when the element is directly "connected" to, "coupled" to, or "contacted" to other elements, but also when the element is "connected", "coupled", or "contacted" by another element between the element and other elements.

In addition, when described as being formed or disposed "on (over)" or "under (below)" of each element, the "on (over)" or "under (below)" may include not only when two elements are directly connected to each other, but also when one or more other elements are formed or disposed between two elements. Further, when expressed as "on (over)" or "under (below)", it may include not only the upper direction but also the lower direction based on one element.

Before describing an embodiment, an electronic device to which a circuit board and a semiconductor package including the same are applied will be described.

### -Electronic device-

Before describing an embodiment, a semiconductor package having a structure in which a chip is mounted on a circuit board of the embodiment may be applied to an electronic device. In this case, the circuit board may be used as an antenna board on which a driving chip for driving the antenna device is mounted, but is not limited thereto..

The electronic device includes a main board (not shown). The main board may be physically and/or electrically connected to various components. For example, the main board may be connected to a package substrate according to an embodiment. Various chips may be mounted on the package substrate. To explain broadly, memory chips such as volatile memory (e.g., DRAM), non-volatile memory (e.g., ROM), and flash memory, application processor chips such as a central processor (e.g., CPU), graphics processor (e.g., GPU), digital signal processor, cryptographic processor, microprocessor, and microcontroller, and logic chips such as analog-digital converters and ASICs (application-specific ICs) can be mounted on the package substrate. In addition, the circuit board of the embodiment may also be used as a package substrate on which a memory chip or a logic chip is mounted.

The circuit board of the embodiment includes a cavity, and thus at least one, and further, at least two or more chips, may be mounted in the cavity. For example, the chip may be an RFIC including a transmitting chip and a receiving chip of an antenna device.

In this case, the electronic device may be a smart phone, a personal digital assistant, a digital video camera, a digital still camera, a vehicle, a high-performance server, a network system, computer, monitor, tablet, laptop, netbook, television, video game, smart watch, automotive, or the like. However, the embodiment is not limited thereto, and may be any other electronic device that processes data in addition to these.

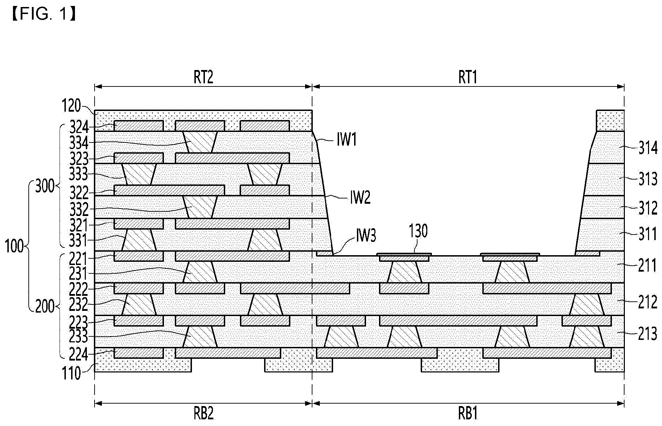

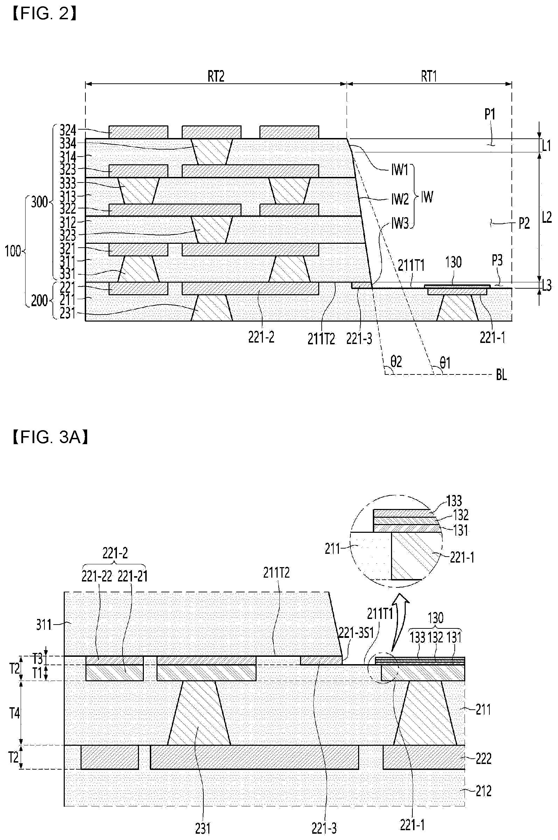

FIG. 1 is a view illustrating a circuit board according to a first embodiment, and FIG. 2 is an enlarged view of a cavity region of FIG. 1.

Hereinafter, the circuit board 100 according to an embodiment will be described with reference to FIGS. 1 and 2. In this case, for convenience of description of the present invention, it will be described that the circuit board 100 is applied to an antenna device.

The circuit board 100 of an embodiment may be provided for driving, feeding, and supporting an antenna unit. For example, the circuit board 100 may be a printed circuit board (PCB). Such a circuit board 100 has a flat plate structure. The circuit board 100 may have a multilayer structure in which a plurality of layers are stacked.

The circuit board 100 may include a ground layer (not shown) for grounding and a feeding part (not shown) for feeding power.

The circuit board 100 of an embodiment may be divided into an antenna unit in which a conductive antenna pattern layer is disposed and a driving unit in which a driving device for driving the antenna unit is disposed. The conductive antenna pattern layer may mean any one of a plurality of circuit layers to be described below.

The conductive antenna pattern layer may be provided for signal transmission and reception in the circuit board of an embodiment. For example, the conductive antenna pattern layer may transmit and receive signals in a predetermined resonant frequency band. For example, the conductive antenna pattern layer may be operated in a resonant frequency band to transmit and receive electromagnetic waves. The conductive antenna pattern layer may operate as power is supplied from a power supply unit (not shown) of the circuit board 100, and a power supply operation of the power supply unit may be performed under the control of the driving unit.

The conductive antenna pattern layer may resonate in a plurality of resonant frequency bands. For example, the conductive antenna pattern layer may be a dual resonant antenna that resonates in different resonant frequency bands. For example, the conductive antenna pattern layer may be a dual resonant antenna that resonates in a first frequency band of 24.03 GHz to 25.81 GHz and a second frequency band of 27.07 GHz to 28.80 GHz, but is not limited thereto. The resonant frequency band of the conductive antenna pattern layer may vary according to the communication standard of the antenna device to which the circuit board is applied.

The circuit board 100 according to an embodiment may include a first substrate layer 200 and a second substrate layer 300.

In this case, the first substrate layer 200 and the second substrate layer 300 do not mean a plurality of substrates manufactured in a separate state and then bonded through a bonding layer, but mean one substrate manufactured through a single manufacturing process. That is, the first substrate layer 200 and the second substrate layer 300 distinguish between a first substrate region in which a cavity C is formed and a second substrate region other than a first substrate region in one circuit board.

The first substrate layer 200 may include one single insulating layer, and differently, may include a plurality of insulating layers sequentially stacked in a thickness direction.

In this case, the first substrate layer 200 may be connected to at least one chip, and may be connected to a main board (not shown) of an antenna device (e.g., an electronic device) including a circuit board of an embodiment, while connecting the chip and a circuit layer.

In this case, the insulating layer of the first substrate layer 200 may have a single-layer structure, but in order to arrange a plurality of signal lines in the first substrate layer 200 having a single-layer structure, a width of the first substrate layer 200 in the horizontal direction may increase, and thus an area occupied by the circuit board in the antenna device may increase. Accordingly, the first substrate layer 200 may include two or more insulating layers to minimize the distance of the signal connection line while reducing the width of the circuit board in the horizontal direction. Hereinafter, it will be described that the first substrate layer 200 has a layer structure of two or more layers. However, the embodiment is not limited thereto, and the first substrate layer 200 may have a single insulating layer structure.

The second substrate layer 300 may be disposed on the first substrate layer 200. The second substrate layer 300 may have a layer structure of at least two layers. The second substrate layer 300 provides a circuit layer and a cavity C. In this case, the circuit layer of the second substrate layer 300 is a conductive antenna pattern layer functioning as an antenna.

When the second substrate layer 300 has a one-layer structure, a sufficient depth of the cavity C formed in the second substrate layer 300 may not be secured, and thus the effect of reducing the thickness in the chip-mounted semiconductor package may be insufficient. In addition, when the second substrate layer 300 has a one-layer structure, an arrangement area of the circuit layer may not be sufficiently secured within a limited space, and thus communication performance may be deteriorated. That is, the communication performance of the antenna pattern increases in proportion to the length of the antenna pattern. In this case, when the second substrate layer 300 has a one-layer structure, the length of the antenna pattern may correspondingly decrease, thereby deteriorating communication performance.

Accordingly, the embodiment allows the second substrate layer 300 to include two or more insulating layers in order to provide a cavity C of sufficient depth (e.g., sufficient depth) for mounting chips while satisfying the communication performance of the antenna pattern. However, the embodiment is not limited thereto, and the second substrate layer 300 may include only one layer of insulating layer depending on a product to which a circuit board of the embodiment is applied or the thickness of a chip mounted in the cavity C.

Hereinafter, the first substrate layer 200 and the second substrate layer 300 according to an embodiment will be described in detail.

The first substrate layer 200 may include an insulating layer, a circuit layer, and a through electrode. The through electrode may also be referred to as a 'connecting part' or a 'via' that functions to connect circuit patterns disposed on different layers.

The first substrate layer 200 may include a first insulating layer. The first insulating layer may have a layer structure of one layer or two or more layers. Although the first insulating layer of the first substrate layer 200 is shown to have a three-layer structure, the embodiment is not limited thereto.

The first insulating layer may include a first-first insulating layer 211, a first-second insulating layer 212, and a first-third insulating layer 213. For example, the first insulating layer may include a first-first insulating layer 211, a first-second insulating layer 212, and a first-third insulating layer 213 disposed in order from a region adjacent to the second substrate layer 300.

The first-first insulating layer 211 may mean a first uppermost insulating layer disposed closest to the second substrate layer 300 among the first insulating layers. Also, the first-third insulating layer 213 may mean a first lowermost insulating layer farthest from the second substrate layer 300 among the first insulating layers. Also, the first-second insulating layer 212 may mean a first inner insulating layer disposed between the first uppermost insulating layer and the first lowermost insulating layer. And, when the first substrate layer 200 has an insulating layer structure of four or more layers, the first inner insulating layer may be formed of a plurality of layers.

The first insulating layer may include a prepreg (PPG). The prepreg may be formed by impregnating a fiber layer in the form of a fabric sheet, such as a glass fabric woven with glass yarn, with an epoxy resin, and then performing thermocompression. However, the embodiment is not limited to this, and the prepreg constituting the first insulating layer 110 may include a fiber layer in the form of a fabric sheet woven with carbon fiber yarn.

The first insulating layer 110 may include a resin and a reinforcing fiber disposed in the resin. The resin may be an epoxy resin, but is not limited thereto. The resin is not particularly limited to the epoxy resin, and for example, one or more epoxy groups may be included in the molecule, or alternatively, two or more epoxy groups may be included, or alternatively, four or more epoxy groups may be included. In addition, the resin of the first insulating layer 110 may include a naphthalene group, for example, may be an aromatic amine type, but is not limited thereto. For example, the resin may be include a bisphenol A type epoxy resin, a bisphenol F type epoxy resin, a bisphenol S type epoxy resin, a phenol novolac type epoxy resin, an alkylphenol novolac type epoxy resin, a biphenyl type epoxy resin, an aralkyl type epoxy resin, dicyclopentadiene type epoxy resin, naphthalene type epoxy resin, naphthol type epoxy resin, epoxy resin of condensate of phenol and aromatic aldehyde having phenolic hydroxyl group, biphenyl aralkyl type epoxy resin, fluorene type epoxy resin resins, xanthene-type epoxy resins, triglycidyl isocyanurate, rubber-modified epoxy resins, phosphorous-based epoxy resins, and the like, and naphthalene-based epoxy resins, bisphenol A-type epoxy resins, and phenol novolac epoxy resins, cresol novolak epoxy resins, rubber-modified epoxy resins, and phosphorous-based epoxy resins. In addition, the reinforcing fiber may include glass fiber, carbon fiber, aramid fiber (e.g., aramid-based organic material), nylon, silica-based inorganic material or titania-based inorganic material. The reinforcing fibers may be arranged in the resin to cross each other in a planar direction.

Meanwhile, the embodiment may use as the glass fiber, carbon fiber, aramid fiber (e.g., aramid-based organic material), nylon, silica-based inorganic material or titania-based inorganic material.

However, the embodiment is not limited thereto, and the first insulating layer may be formed of an insulating material other than the prepreg.

In addition, unlike this, at least one of the plurality of insulating layers that make up the first insulating layer may include a prepreg, and the other insulating layer may include an insulating material other than the prepreg.

For example, at least one of the plurality of insulating layers of the first insulating layer may be rigid or flexible. For example, at least one of the plurality of insulating layers of the first insulating layer may include glass or plastic. In detail, at least one of the plurality of insulating layers of the first insulating layer may include chemical strengthened glass/heat strengthened glass such as soda lime glass or aluminosilicate glass, or reinforced or soft plastic such as polyimide (PI), polyethylene terephthalate (PET), propylene glycol (PPG) polycarbonate (PC), or sapphire. For example, at least one of the plurality of insulating layers of the first insulating layer may include a photo-isotropic film. For example, at least one of the plurality of insulating layers of the first insulating layer may include a cyclic olefin copolymer (COC), a cyclic olefin polymer (COP), a photo-isotropic polycarbonate (PC), a photo-isotropic polymethyl methacrylate (PMMA), or the like. For example, at least one of the plurality of insulating layers of the first insulating layer may be formed of a material including an inorganic filler and an insulating resin. For example, a material constituting at least one of the plurality of insulating layers of the first insulating layer may include a reinforcing material such as an inorganic filler such as silica or alumina together with a thermosetting resin such as an epoxy resin or a thermoplastic resin such as polyimide, and specifically, may be an ABF (Ajinomoto Build-up Film), FR-4, Bismaleimide Triazine (BT), Photo Image-able Dielectric Resin (PID), BT, etc. For example, at least one of a plurality of insulating layers of the first insulating layer may be formed of a resin coated copper (RCC).

Each insulating layer of the first insulating layer may have a thickness in a range of 10 µm to 60 µm. For example, each of the first-first insulating layer 211, the first-second insulating layer 212, and the first-third insulating layer 213 of the first insulating layer may have a thickness in a range of 10 µm to 60 µm. For example, each of the first-first insulating layer 211, the first-second insulating layer 212, and the first-third insulating layer 213 may have a thickness in a range of 12 µm to 45 µm. For example, each of the first-first insulating layer 211, the first-second insulating layer 212, and the first-third insulating layer 213 may have a thickness of 15 µm to 30 µm.

Each thickness of the first-first insulating layer 211, the first-second insulating layer 212, and the first-third insulating layer 213 may mean a vertical distance between different circuit layers adjacent to each other. When the thickness of each of the first-first insulating layer 211, the first-second insulating layer 212, and the first-third insulating layer 213 is less than 10 µm, a distance between different circuit layers corresponding thereto becomes close, and thus may be weakened to noise due to signal interference therebetween. When each thickness of the first-first insulating layer 211, the first-second insulating layer 212, and the first-third insulating layer 213 exceeds 60 µm, the overall thickness of the circuit board may increase. Also, when each thickness of the first-first insulating layer 211, the first-second insulating layer 212, and the first-third insulating layer 213 exceeds 60 µm, the thickness of the through electrode may also increase, and accordingly, the signal transmission distance may increase, thereby increasing signal transmission loss.

The first substrate layer 200 of an embodiment may include a first circuit layer. For example, the first substrate layer 200 may include a first circuit layer including a plurality of pattern layers disposed on a plurality of insulating layers of the first insulating layer, respectively.

For example, the first substrate layer 200 may include a first pattern layer 221 disposed on an upper surface of the first-first insulating layer 211. For example, the first substrate layer 200 may include a second pattern layer 222 disposed between the lower surface of the first-first insulating layer 211 and an upper surface of the first-second insulating layer 212. For example, the first substrate layer 200 may include a third pattern layer 223 disposed between a lower surface of the first-second insulating layer 212 and an upper surface of the first-third insulating layer 213. For example, the first substrate layer 200 may include a fourth pattern layer 224 disposed on a lower surface of the first-third insulating layer 213.

The first pattern layer 221 may be disposed in the first-first insulating layer 211. For example, at least a portion of a side surface of the first pattern layer 221 may be covered by the first-first insulating layer 211. Preferably, the first pattern layer 221 may have a buried structure in which at least a portion of a side surface and a lower surface thereof are covered by the first-first insulating layer 211 while an upper surface thereof is exposed.

The first pattern layer 221 may refer to a circuit layer disposed at an uppermost side of the circuit layers of the first substrate layer.

The first pattern layer 221 may have different heights depending on a position. For example, the first pattern layer 221 includes a plurality of pattern parts, a height of an upper surface of at least one of the plurality of pattern parts may be different from a height of an upper surface of at least another one of the plurality of pattern parts. For example, an upper surface of at least one of a plurality of pattern parts of the first pattern layer 221 may have a step difference from an upper surface of at least another one of the plurality of pattern parts. In addition, a lower surface of at least one of a plurality of pattern parts of the first pattern layer 221 may have a different height or step difference from a lower surface of at least another one of the plurality of pattern parts. In addition, a thickness of at least one of a plurality of pattern parts of the first pattern layer 221 may be different from a thickness of at least another one of the plurality of pattern parts of the first pattern layer 221.

For example, the first substrate layer 200 may be divided into a plurality of regions in a width direction or a length direction.

The first substrate layer 200 may include a first region RB1 that vertically overlaps the cavity C and a second region RB2 other than the first region RB1. In this case, the cavity C may include a region whose width changes in a thickness direction. In addition, the first region RB1 may mean a region that vertically overlaps a region having a largest width among the entire regions of the cavity C. However, an embodiment is not limited thereto, the first region RB1 may mean a region vertically overlapping with a region having a smallest width among all regions of the cavity C, or may mean a region vertically overlapping with one region between the upper region and the lower region of the cavity C.

The first pattern layer 221 includes a plurality of pattern parts. For example, the first pattern layer 221 may include a first pattern part 221-1 disposed on an upper surface of the first region RB1 of the first-first insulating layer 211, and a second pattern part 221-2 disposed on an upper surface of the second region RB2 of the first-first insulating layer 211. Also, the first substrate layer 200 includes a boundary region between the first region RB1 and the second region RB2. The boundary region may overlap at least a portion of the first region RB1 and/or the second region RB2. The boundary region may mean a region vertically overlapping at least a portion of an inner wall of the cavity C. In addition, the first pattern layer 221 may include a third pattern part 221-3 disposed in the boundary region.

In this case, a thickness of at least one of the first to third pattern parts 221-1, 221-2, and 221-3 of the first pattern layer 221 may be different from a thickness of at least another one of the first to third pattern parts 221-1, 221-2, and 221-3 of the first pattern layer 221. In addition, an upper surface of at least one of the first to third pattern parts 221-1, 221-2, and 221-3 of the first pattern layer 221 may be positioned on a plane different from an upper surface of at least another one of the first to third pattern parts 221-1, 221-2, and 221-3 of the first pattern layer 221. In addition, a lower surface of at least one of the first to third pattern parts 221-1, 221-2, and 221-3 of the first pattern layer 221 may be positioned on a plane different from a lower surface of at least another one of the first to third pattern parts 221-1, 221-2, and 221-3 of the first pattern layer 221.

Preferably, the upper surface of the first pattern part 221-1 may be located lower than the upper surface of the second pattern part 221-2 and the upper surface of the third pattern part 221-3. In addition, the first pattern part 221-1 functions as a mounting pad on which a chip is mounted. In this case, in the embodiment, the first pattern part 221-1 is positioned lower than the second pattern part 221-2 and the third pattern part 221-3, so that the first pattern part 221-1 may be prevented from being damaged in the laser process for forming the cavity C, thereby improving the mounting reliability of the chip.

A thickness of each of the first pattern part 221-1, the second pattern part 221-2, and the third pattern part 221-3, and a positional relationship between the upper and lower surfaces will be described in detail below.

Meanwhile, the first circuit layer including the first pattern layer 221, the second pattern layer 222, the third pattern layer 223, and the fourth pattern layer 224 may be formed of at least one metal material selected from gold (Au), silver (Ag), platinum (Pt), titanium (Ti), tin (Sn), copper (Cu), and zinc (Zn). The first circuit layers may be formed of a paste or a solder paste including at least one metal material selected from among gold (Au), silver (Ag), platinum (Pt), titanium (Ti), tin (Sn), copper (Cu), and zinc (Zn) having excellent bonding strength. Preferably, the first circuit layer may be formed of copper (Cu) which has high electrical conductivity and is relatively inexpensive.

The first circuit layer may have a thickness in a range of 5 µm to 50 µm. For example, each pattern layer of the first circuit layer may have a thickness in a range of 10 µm to 40 µm. For example, the first circuit layer may have a thickness in a range of 15 µm to 30 µm. When a thickness of the first circuit layer is less than 5 µm, a resistance of the circuit layer may increase, and thus the signal transmission loss may increase. When the thickness of each pattern layer of the first circuit layer is less than 5 µm, an allowable current of a signal that may be transmitted to the first circuit layer may decrease, and thus communication performance such as a decrease in a signal transmission speed may deteriorate. Also, when the thickness of the first circuit layer exceeds 50 µm, a line width of each pattern part of the first circuit layer increases, and accordingly, it may be difficult to refine the pattern part. In addition, when the thickness of the first circuit layer exceeds 50 µm, a thickness of the circuit board may increase.

On the other hand, the first circuit layer above can be formed using the typical circuit board manufacturing process such as Additive Process, Subactive Process, MSAP (Modified Semi Additive Process), and SAP (Semi Additive Process), and detailed explanations are omitted here.

Meanwhile, the first substrate layer 200 includes a through part. For example, the through part may be formed to pass through each insulating layer of the first substrate layer 200.

For example, the through part may include a first through electrode 231 passing through the first-first insulating layer 211. For example, the through part may include a first through electrode 231 passing through the first-first insulating layer 211 and electrically connecting the first pattern layer 221 and the second pattern layer 222.

In addition, the through part may include a second through electrode 232 passing through the first-second insulating layer 212. For example, the through part may include a second through electrode 232 passing through the first-second insulating layer 212 and connecting the second pattern layer 222 and the third pattern layer 223.

The through part may include a third through electrode 233 passing through the first-third insulating layer 213. For example, the through part may include a third through electrode 233 passing through the first-third insulating layer 213 and electrically connecting the third pattern layer 223 and the fourth pattern layer 224.

The through part may be formed by filling the inside of a through hole passing through each of the insulating layers of the first insulating layer with a conductive material. The through hole may be formed by any one of mechanical, laser, and chemical processing. When the through hole is formed by machining, it can be formed using methods such as milling, drilling, and routing. When the through hole is formed by laser processing, it can be formed using methods such as UV or CO₂ laser. When the through hole is formed by chemical processing, it can be formed using a chemical containing amino silane, ketones, or the like. Accordingly, at least one of the plurality of insulating layers may be opened.

Meanwhile, the laser processing is a cutting method that concentrates optical energy on a surface to melt and evaporate a part of the material to take a desired shape, accordingly, complex formations by computer programs can be easily processed, and even composite materials that are difficult to cut by other methods can be processed.

In addition, the laser processing has a cutting diameter of at least 0.005mm, and has a wide range of possible thicknesses. As the laser processing drill, it is preferable to use a YAG (Yttrium Aluminum Garnet) laser, a CO₂ laser, or an ultraviolet (UV) laser. YAG laser is a laser that can process both copper foil layers and insulating layers, and CO₂ laser is a laser that can process only insulating layers.

When the through hole is formed, each through electrode may be formed by filling the inside of the through hole with a conductive material. A metal material forming the through electrode may be any one material selected from copper (Cu), silver (Ag), tin (Sn), gold (Au), nickel (Ni), and palladium (Pd). In addition, the conductive material filling may use any one or a combination of electroless plating, electrolytic plating, screen printing, sputtering, evaporation, ink-jetting and dispensing.

The second substrate layer 300 may include a plurality of second insulating layers. For example, the second substrate layer 300 may include a second-first insulating layer 311, a second-second insulating layer 312, a second-third insulating layer 313, and a second-fourth insulating layer 314.

For example, the second substrate layer 300 may include four layers of insulating layer. However, the embodiment is not limited thereto, and the second insulating layer of the second substrate layer 300 may include three or less insulating layers and may include five or more insulating layers.

The second-first insulating layer 311 may be disposed on the first substrate layer 200. For example, the second-first insulating layer 311 may be disposed on an upper surface of the first-first insulating layer 211 disposed at an uppermost side of the first substrate layer 200.

The second-second insulating layer 312 may be disposed on the second-first insulating layer 311. Also, the second-third insulating layer 313 may be disposed on the second-second insulating layer 312. Also, the second-fourth insulating layer 314 may be disposed on the second-third insulating layer 313.

The second insulating layer of the fourth layer of the second substrate layer 300 may include the same insulating material as the first insulating layer of the first substrate layer 200, but is not limited thereto.

The second substrate layer 300 may include a second circuit layer.

For example, the second circuit layer may include a fifth pattern layer 321 disposed on the upper surface of the second-first insulating layer 311. For example, the second circuit layer may include a sixth pattern layer 322 disposed on the upper surface of the second-second insulating layer 312. For example, the second circuit layer may include a seventh pattern layer 323 disposed on the upper surface of the second-third insulating layer 313. For example, the second circuit layer may include an eighth pattern layer 324 disposed on the upper surface of the second-fourth insulating layer 314.

In this case, the second circuit layer of the second substrate layer 300 may be a conductive antenna pattern layer functioning as an antenna. For example, the fifth pattern layer 321, the sixth pattern layer 322, the seventh pattern layer 323, and the eighth pattern layer 324 may be connected to the first circuit layer of the first substrate layer 200. Accordingly, the fifth pattern layer 321, the sixth pattern layer 322, the seventh pattern layer 323, the eighth pattern layer 324 may be an antenna unit functioning to transmit a transmission signal to an outside or to receive a signal transmitted from an outside.

The second substrate layer 300 may include a second through part. For example, the second substrate layer 300 may include a plurality of through electrodes passing through the second insulating layer, respectively.

For example, the second through part may include a fourth through electrode 331 passing through the second-first insulating layer 311. The fourth through electrode 331 may electrically connect the first pattern layer 221 of the first substrate layer 200 and the fifth pattern layer 321. For example, the second through part may include a fifth through electrode 332 passing through the second-second insulating layer 312. The fifth through electrode 332 may electrically connect the fifth pattern layer 321 and the sixth pattern layer 322. For example, the second through part may include a sixth through electrode 333 passing through the second-third insulating layer 313. The sixth through electrode 333 may electrically connect the sixth pattern layer 322 and the seventh pattern layer 323. For example, the second through electrode 333 may include a seventh through electrode 334 passing through the second-fourth insulating layer 314. The seventh through electrode 334 may electrically connect the seventh pattern layer 323 and the eighth pattern layer 334.

Meanwhile, the second substrate layer 300 includes a cavity C.

Accordingly, the second substrate layer 300 may include a region in which the cavity C is formed, for example, a third region RT1 vertically overlapping the cavity C and a fourth region RT2 other than the third region RT1.

The third region RT1 may be a region vertically overlapping the first region RB1 of the first substrate layer 200. The fourth region RT2 may be a region vertically overlapping the second region RB2 of the first substrate layer 200.

In addition, a cavity C of a mounting space in which chips such as a driving device or a passive device are mounted may be formed in the third region RT1 of the second substrate layer 300 in a package substrate. In addition, a second circuit layer, which is an antenna pattern functioning as an antenna, may be formed in the fourth region RT2 of the second substrate layer 300.

In this case, when the circuit board 100 of the present application is an antenna board applied to an antenna device, circuit layers disposed on each layer of the circuit board may perform different functions.

For example, each of the first pattern layer 221, the second pattern layer 222, the third pattern layer 223, and the fourth pattern layer 224 of the first circuit layer of the first substrate layer 200 may include a first circuit part vertically overlapping a first region RB1. In addition, first circuit part may vertically overlap the cavity C. The first circuit part may function as a mounting pad on which a chip such as a driving device or a passive device is mounted. Alternatively, the first circuit part may function as a terminal pad connecting an external substrate (e.g., a main board of a terminal) and a circuit board according to an embodiment.

Also, each of the first pattern layer 221, the second pattern layer 222, the third pattern layer 223, and the fourth pattern layer 224 of the first circuit layer may include a second circuit part vertically overlapping the second region RB2. In addition, the second circuit part may vertically overlap the second circuit layers formed in the fourth region RT2 of the second substrate layer 300.

In this case, the second circuit parts of the first circuit layer according to an embodiment may function as a terminal pad together with the first circuit part. In a case in which the second circuit part functions as a terminal pad together with the first circuit part, the circuit board according to an embodiment may function as an antenna only in the fourth region RT2 of the second substrate layer 300. For example, in a case in which the second circuit part of the first circuit layer does not function as an antenna pattern, the circuit board according to an embodiment may transmit a transmission signal to an upper side of the fourth region RT2 of the second substrate layer 300 or receive a signal received from an upper side of the fourth region RT2.

In addition, according to another embodiment, the second circuit part may be connected to the second circuit layers disposed in the fourth region RT2 of the second substrate layer 300, and may function as an antenna pattern that transmits or receives a signal.

For example, the second circuit layer may be referred to as the first antenna pattern layer in the fourth region RT2 of the second substrate layer 300, and a second circuit part disposed in a region vertically overlapping the second region RB2 among the second circuit layers of the first substrate layer 200 may be a second antenna pattern layer connected to the first antenna pattern layer. Accordingly, the embodiment may transmit signals in both directions of the circuit board or receive signals transmitted in both directions of the circuit board. For example, the embodiment may transmit signals to an upper side of the first antenna pattern layer, and may transmit signals to a lower side of the second antenna pattern layer. Also, the embodiment may receive signals transmitted from the upper side of the first antenna pattern layer and may receive signals transmitted from the lower side of the second antenna pattern layer.

Meanwhile, in an embodiment, all of the first circuit layers of the first substrate layer 200 that vertically overlap the first region RB1 function as mounting pads or terminal pads, but are not limited thereto. For example, some of the first circuit parts disposed on the first region RB1 of the first substrate layer 200 may function as a mounting pad or a terminal pad, and the remaining part may function as an antenna pattern together with the second antenna pattern layer.

Meanwhile, the circuit board 100 may include a protective layer. For example, the circuit board 100 may include a first protective layer 110 disposed on a lower surface of an insulating layer disposed at a lowermost side of the first substrate layer 200. For example, the circuit board 100 may include a second protective layer 120 disposed on an upper surface of an insulating layer disposed at an uppermost side of the second substrate layer 300.

The first protective layer 110 and the second protective layer 120 may be resist layers. For example, the first protective layer 110 and the second protective layer 120 may be solder resist layers including an organic polymer material. For example, the first protective layer 110 and the second protective layer 120 may include an epoxy acrylate-based resin. Specifically, the first protective layer 110 and the second protective layer 120 may include a resin, a curing agent, a photo initiator, a pigment, a solvent, a filler, an additive, an acrylic-based monomer, and the like. However, embodiments are not limited thereto, and the first protective layer 110 and the second protective layer 120 may be any one of a photo solder resist layer, a cover-lay, and a polymer material.

The first protective layer 110 and the second protective layer 120 may have a thickness of about 1 µm to about 20 µm. The first protective layer 110 and the second protective layer 120 may have a thickness of about 1 µm to about 15 µm. For example, the first protective layer 110 and the second protective layer 120 may have a thickness of about 5 µm to about 20 µm. When the thicknesses of the first protective layer 110 and the second protective layer 120 are greater than about 20 µm, the thickness of the circuit board may increase. When the thicknesses of the first protective layer 110 and the second protective layer 120 are less than about 1 µm, pattern layers included in the circuit board may not be stably protected, and thus, electrical or physical reliability may be deteriorated.

Meanwhile, the circuit board 100 includes a barrier layer 130. The barrier layer 130 may be formed in a region vertically overlapping the cavity C.

Specifically, the barrier layer 130 may be disposed on the first pattern part 221-1 of the first pattern layer 221. Preferably, the barrier layer 130 may be disposed on the surface of the first pattern part 221-1 exposed through the cavity C. In this case, the first pattern part 221-1 in FIGS. 1 and 2 has a structure in which an upper surface is exposed through the cavity C. For example, the side surface and the lower surface of the first pattern part 221-1 of an embodiment are covered by the first insulating layer, and the upper surface of the first pattern part 221-1 is exposed through the cavity C. In addition, the barrier layer 130 may be disposed on the upper surface of the first pattern part 221-1 exposed through the cavity C.

The barrier layer 130 may also be a surface treatment layer for protecting the upper surface of the first pattern part 221-1 exposed through the cavity C. The barrier layer 130 may have a different layer structure according to surface treatment methods. For example, the barrier layer 130 may be formed by an Electroless Nickel Electroless Palladium Immersion Gold (ENEPIG) method. Accordingly, the barrier layer 130 may include first to third barrier layers. Unlike this, the barrier layer 130 may be formed by an Electroless Nickel Immersion Gold (ENIG) method. Accordingly, the barrier layer 130 may include first and second barrier layers. A detailed layer structure of the barrier layer 130 will be described below in more detail.

Hereinafter, the thickness and positional relationship of each pattern part of the cavity C and the first pattern layer 221 of the embodiment, and the layer structure of the barrier layer 130 will be described in detail.

Referring to FIG. 2, the cavity C of an embodiment penetrates the second substrate layer 300. For example, the cavity C penetrates the second insulating layer. When the second insulating layer has a plurality of layer structures, the cavity C may commonly penetrate the second insulating layer of the plurality of layers. The cavity C may include a plurality of parts. For example, the cavity C may be divided into a plurality of parts in a thickness direction. In this case, a plurality of parts of the cavity C may be divided based on an inclination of an inner wall IW of the cavity C.

For example, the cavity C may include a first part P1 adjacent to an upper surface of the second substrate layer 300. In addition, the cavity C may include a second part P2 adjacent to a lower surface of the second substrate layer 300 and positioned below the first part P1.

In this case, the first part P1 may include a region whose width decreases toward the lower surface of the second substrate layer 300. For example, the inner wall IW1 of the first part P1 may have a first slope whose width decreases toward the first substrate layer 200. The first slope of the inner wall IW of the first part P1 may mean an inner angle between a reference line BL and a virtual straight line connected to the inner wall IW The reference line BL may be parallel to an upper surface of the first substrate layer 200 vertically overlapping the cavity C.

Meanwhile, the first slope θ1 of the inner wall IW1 of the first part P1 may have a range between 115 and 150 degrees. For example, the first slope θ1 of the inner wall IW1 of the first part P1 may have a range between 118 and 148 degrees. For example, the first slope θ1 of the inner wall IW1 of the first part P1 may have a range between 120 and 145 degrees.

When the first slope θ1 of the inner wall IW1 of the first part P1 is less than 115 degrees, a process time required for forming the cavity C according to the embodiment may increase. For example, the first slope θ1 of the inner wall IW1 of the first part P1 means that a laser beam width (e.g., laser mask) used in a process of forming the primary cavity described below is small, and thus the time required to form the cavity C may increase.

In addition, when the first slope θ1 of the inner wall IW1 of the first part P1 is greater than 150, circuit integration may decrease as the width of the upper part of the cavity C increases. For example, the width of the cavity C is determined to correspond to the arrangement space of the devices to be mounted, and the cavity formation process is performed based on the determined lower width. In this case, when the upper width of the cavity C increases, it means that the space wasted meaninglessly increases, and accordingly, the arrangement space of the circuit layer may decrease as the upper width of the cavity C increases. Accordingly, in an embodiment, the first slope θ1 of the inner wall IW1 of the first part P1 is in a range between 115 degrees and 150 degrees.

Meanwhile, the cavity C of an embodiment includes a second part P2 positioned under the first part P1. The second part P2 may include a region whose width decreases toward the lower surface of the second substrate layer 300. For example, the second part P2 may include an inner wall IW2 whose width decreases toward the first substrate layer 200 and has a second slope (θ2) different from the first slope (θ1) of the inner wall (IW1) of the first part P1. For example, the second slope θ2 of the second part P2 may be smaller than the first slope θ1 of the first part P1.

In this case, the second slope θ2 may mean a slope of the inner wall IW2 of the second part P2. For example, the second slope θ2 may mean an inner angle between a reference line BL and a virtual straight line extending from the inner wall IW2 of the second part P2.

The second slope θ2 of the inner wall IW2 of the second part P2 may be smaller than the first slope θ1 and may have a range between 91 and 120 degrees. For example, the second slope θ2 of the inner wall IW2 of the second part P2 may be smaller than the first slope θ1 and may have a range between 95 and 118 degrees. For example, the second slope θ2 of the inner wall IW2 of the second part P2 may be smaller than the first slope θ1 and may have a range between 98 and 115 degrees.

When the second slope θ2 of the inner wall IW2 of the second part P2 is less than 91 degrees, a chip such as a driving device or a passive device may not be stably disposed in the cavity C. Specifically, when the second slope θ2 of the inner wall IW2 of the second part P2 is less than 91 degrees, the second part P2 may have a shape whose width decreases toward the upper surface of the second substrate layer 300, and a sufficient chip arrangement space may not be provided in the intermediate region of the cavity C. For this reason, the inner wall of the cavity C and the chip may come into contact with each other in an intermediate region of the cavity C, which may cause a problem that the mounting position of the chip is twisted or the chip is mounted in an inclined state in the mounting process of the chip.

In addition, when the second slope θ2 of the inner wall IW2 of the second part P2 is greater than 120 degrees, the cavity C may be formed with a size larger than that required for the device mounting space. Accordingly, when the second slope θ2 of the inner wall IW2 of the second part P2 is greater than 120 degrees, it means that the difference between the width of the lower region and the width of the upper region of the second part P2 is large. In addition, a width of a general cavity determines the width of the lower region of the second part P2 corresponding to the size of the chip. When the second slope θ2 of the inner wall IW2 of the second part P2 is greater than 120 degrees, the space or area occupied by the cavity C may increase compared to the size of the chip, resulting in a decrease in circuit integration or an increase in a width of the circuit board in the horizontal direction or a thickness in the vertical direction.

Meanwhile, lengths of the first part P1 and the second part P2 of the cavity C may be different from each other. For example, the first part P1 of the cavity C may have a first length L1, and the second part P2 may have a second length L2 longer than the first length L1. In this case, the first length L1 may mean a depth of the first part P1 in a vertical direction. For example, the first length L1 may mean a vertical distance of the first part P1. Also, the second length L2 may mean a depth of the second part P2. For example, the second length L2 may mean a depth or a distance of the second part P2 in the vertical direction.

In this case, the second length L2 may be 1.5 times or more. For example, the second length L2 may be 3 times or more. For example, the second length L2 may be 5 times or more. For example, the second length L2 may be 10 times or more of the first length L1.

For example, the second length L2 may satisfy a range between 1.5 and 30 times the first length L1. For example, the second length L2 may satisfy a range between 3 and 28 times the first length L1. For example, the second length L2 may satisfy a range between 5 and 25 times the first length L1. For example, the second length L2 may satisfy a range between 10 to 20 times the first length L1.

In this case, when the second length L2 is less than 1.5 times the first length L1, an effect generated due to a difference between the first slope of the first part P1 and the second slope of the second part P2 may be insufficient. Also, when the second length L2 is more than 30 times the first length L1, the thickness of the second substrate layer 300 for satisfying the same may increase, and accordingly, the overall thickness of the circuit board may increase.

Meanwhile, the cavity C according to an embodiment may include a third part P3 below the second part P2. The third part P3 may be positioned lower than the second substrate layer 300. The third part P3 of the cavity C may be provided in the first substrate layer 200, not the second substrate layer 300. For example, the third part P3 of the cavity C may overlap at least a portion of the first pattern layer 221 of the first substrate layer 200 in a horizontal direction. That is, the third part P3 may be provided by removing at least one pattern part of the first pattern layer 221 by etching. Furthermore, the third part P3 may be formed by removing a part of the first region RB1 of the first-first insulating layer 211 disposed at the uppermost side of the first substrate layer 200, together with a part of the first pattern layer 221. Specifically, the third part P3 may be provided by removing a part of a laser stopper layer (e.g., a part of the third pattern part 221-3 of the fist pattern layer 221) formed in a region vertically overlapping the cavity C of the first pattern layer 200.

For example, a total depth of the cavity C may be greater than a total thickness of the second insulating layer of the second substrate layer 300. For example, a depth of the cavity C in the first embodiment may be greater than a total thickness of the second insulating layer by the thickness of the third pattern part 221-3.

Accordingly, a lower surface of the cavity C may be positioned lower than a lower surface of the second substrate layer 300.

The third part P3 may have a third slope. The third slope may mean a slope of the inner wall IW3 of the third part P3. In this case, the inner wall IW1 of the first part P1 and the inner wall IW2 of the second part P2 mean an inner wall of the second insulating layer of the second substrate layer 300. Unlike this, the inner wall IW3 of the third part P3 of the first embodiment may mean a side surface of the third pattern part 221-3 of the first pattern layer 221.

Specifically, the first pattern layer 221 of the first substrate layer 200 includes a third pattern part 221-3 disposed to surround a boundary region between the first region RB1 and the second region RB2. The third pattern part 221-3 may be a part of a stopper layer used as a laser stopper in a laser process of forming the cavity C. A lower width of the cavity C may be less than the width of the stopper layer. If the cavity C having the same lower width as the width of the stopper layer is formed, a part of the upper surface of the first-first insulating layer 211 adjacent to the edge of the stopper layer may be laser-processed due to a process deviation in the laser process, and thus a reliability problem may occur. Accordingly, the cavity C has a lower width smaller than the width of the stopper layer. Accordingly, a part of the stopper layer may be exposed through the cavity C, and the remaining part may not be exposed through the cavity C. In this case, the stopper layer through which the upper surface is exposed through the cavity C may be removed by etching to form the third part P3 of the cavity C. The stopper layer through which the upper surface is not exposed through the cavity C is not removed during the etching process, and accordingly, the third pattern part 221-3 of the first pattern layer 221 may constitute. The third slope of the inner wall IW3 of the third part P3 of the cavity C may mean an inclination angle of the side surface of the third pattern part 221-3. The third slope of the inner wall IW3 of the third part P3 may be determined by etching conditions of the stopper layer.

For example, in the first embodiment, the third slope of the inner wall IW3 of the third part P3 may be perpendicular to the reference line BL.

Meanwhile, the upper surface of the first substrate layer 200 according to an embodiment may have a step difference. For example, the upper surface of the first-first insulating layer 211 may have a step difference. Specifically, the upper surface of the first-first insulating layer 211 may include a first upper surface 211T1 and a second upper surface 211T2 having a step difference from the first upper surface 211 T1. The first upper surface 211T1 of the first-first insulating layer 211 may form a lower surface or a bottom surface of the cavity C.

For example, the upper surface of the first-first insulating layer 211 may include a first upper surface 211T1 vertically overlapping the cavity C, and a second upper surface 211T2 not vertically overlapping the cavity C. That is, the first upper surface 211T1 of the first-first insulating layer 211 may correspond to a first region RB1 of the first substrate layer 200, and the second upper surface 211T2 of the first-first insulating layer 211 may correspond to a second region RB2 of the first substrate layer 200. Also, the first upper surface 211T1 of the first-first insulating layer 211 may be a lower surface of the cavity C, and may be a portion not in contact with the second substrate layer 300. Also, the second upper surface 211T2 of the first-first insulating layer 211 may have a step difference from the lower surface of the cavity C, and may mean a portion in contact with the second substrate layer 300. The second upper surface 211T2 of the first-first insulating layer 211 may not vertically overlap the first upper surface 211T1.

In this case, the first upper surface 211T1 may include a first overlapping region vertically overlapping the first pattern part 221-1 and a first non-overlapping region vertically overlapping the first pattern part 221-1.

In addition, the second upper surface 211T2 includes a second overlapping region vertically overlapping the second pattern part 221-2, a third overlapping region vertically overlapping the third pattern part 221-3, and a second non-overlapping region that does not vertically overlap the second pattern part 221-2 and the third pattern part 221-3.

In this case, in the circuit board of the comparative example, the first non-overlapping region of the first upper surface 211T1 of the first-first insulating layer 211 is positioned on the same plane as the second non-overlapping region of the second upper surface 211T2. Alternatively, the first non-overlapping region of the first upper surface 211T1 of the first-first insulating layer 211 of the embodiment may be positioned on a different plane from the second non-overlapping region of the second upper surface 211T2. For example, the first non-overlapping region of the first upper surface 211T1 of the first-first insulating layer 211 may be positioned lower than the second non-overlapping region of the second upper surface 211T2. For example, the first non-overlapping region of the first embodiment may be positioned lower by the thickness of the third pattern part 221-3 than the second non-overlapping region. Hereinafter, the first upper surface 211T1 of the first-first insulating layer 211 may mean the first non-overlapping region, and the second upper surface 211T2 of the first-first insulating layer 211 may mean the second non-overlapping region.

The first upper surface 211T1 of the first-first insulating layer 211 may be positioned higher than the lower surface of the second pattern part 221-2 of the first pattern layer 221. The first upper surface 211T1 of the first-first insulating layer 211 may be positioned on the same plane as the lower surface of the third pattern part 221-3. In this case, being positioned on the same plane may mean that a height difference therebetween is 1 µm or less, 0.5 µm or less, or 0.1 µm or less. Alternatively, being positioned on the same plane may mean that a height difference therebetween is 5% or less, 3% or less, or 1% or less of a thickness of the third pattern part 221-3.

The second upper surface 211T2 of the first-first insulating layer 211 may be positioned higher than the upper surface of the first pattern part 221-1 of the first pattern layer 221. The second upper surface 211T2 of the first-first insulating layer 211 may be positioned on the same plane as the upper surface of the third pattern part 221-3. In this case, being positioned on the same plane may mean that a height difference therebetween is 1 µm or less, 0.5 µm or less, or 0.1 µm or less. Alternatively, being positioned on the same plane may mean that a height difference therebetween is 5% or less, 3% or less, or 1% or less of a thickness of the third pattern part 221-3.

The first upper surface 211T1 and the second upper surface 211T2 of the first-first insulating layer 211 may have surface roughness different from each other. For example, the first upper surface 211T1 of the first-first insulating layer 211 may have a surface roughness corresponding to that of the lower surface of the first pattern layer 221 formed through the plating process. Alternatively, the second upper surface 211T2 of the first-first insulating layer 211 may have a surface roughness corresponding to that of the lower surface of the second-first insulating layer 311.

The first pattern part 221-1 of the first pattern layer 221 of the first embodiment is disposed in a first region RB1 vertically overlapping the cavity C. Also, the second pattern part 221-2 of the first pattern layer 221 is disposed in a second region RB2 that does not vertically overlap the cavity C. Also, the third pattern part 221-3 of the first pattern layer 221 is disposed in a boundary region between the first region RB1 and the second region RB2.

Any one of the first pattern part 221-1, the second pattern part 221-2, and the third pattern part 221-3 may have a thickness different from that of another one of the first pattern part 221-1, the second pattern part 221-2, and the third pattern part 221-3. An upper surface of any one of the first pattern part 221-1, the second pattern part 221-2, and the third pattern part 221-3 may be positioned on a plane different from an upper surface of another one of the first pattern part 221-1, the second pattern part 221-2, and the third pattern part 221-3. For example, a lower surface of any one of the first pattern part 221-1, the second pattern part 221-2, and the third pattern part 221-3 may be positioned on a plane different from a lower surface of another one of the first pattern part 221-1, the second pattern part 221-2, and the third pattern part 221-3.

Hereinafter, the thickness of each of the first pattern part 221-1, the second pattern part 221-2, and the third pattern part 221-3 of the first pattern layer 221 and the positional relationship thereof, and the layer structure of the barrier layer 130 will be described with reference to the drawings.

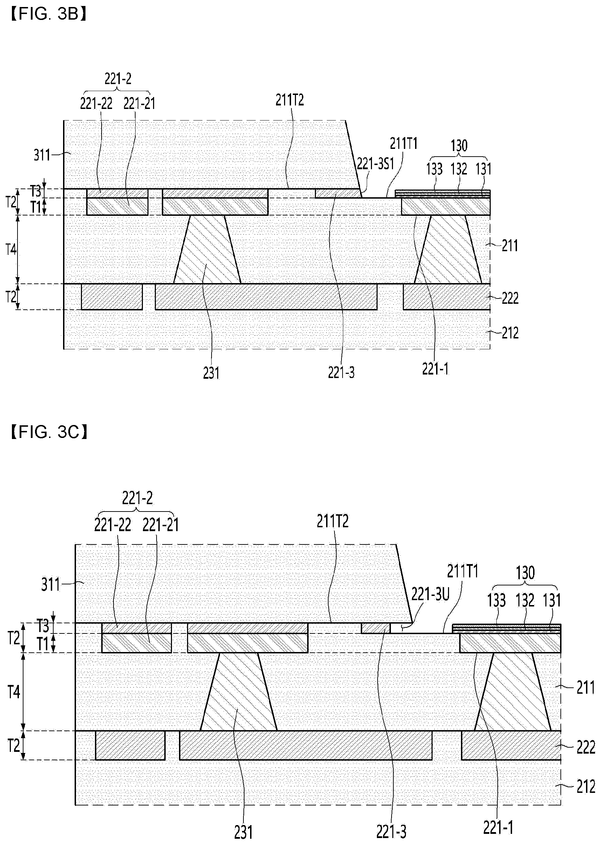

FIG. 3A is an enlarged view of an arrangement region of a first pattern layer of a circuit board according to a first embodiment, FIG. 3B is an enlarged view of an arrangement region of a first pattern layer of a circuit board according to a second embodiment, and FIG. 3C is an enlarged view of an arrangement region of a first pattern layer of a circuit board according to a third embodiment.

Referring to FIG. 3A, the first pattern layer 221 includes a first pattern part 221-1, a second pattern part 221-2, and a third pattern part 221-3.

The first pattern part 221-1 is disposed in the first region RB1 of the first-first insulating layer 211. That is, the first pattern part 221-1 may vertically overlap the cavity C. An upper surface of the first pattern part 221-1 may be positioned lower than upper surfaces of other pattern parts(for example, the second pattern part 221-2 and the third pattern part 221-3) of the first pattern layer 221. For example, the upper surface of the first pattern part 221-1 may be positioned lower than the second upper surface 211T2 of the first-first insulating layer 211. For example, the upper surface of the first pattern part 221-1 may be positioned lower than a lowermost side of the second substrate layer 300. The first pattern part 221-1 may have a first thickness T1. A specific feature of the first thickness T1 will be described below.

The second pattern part 221-2 may be disposed in the second region RB2 of the first-first insulating layer 211. The second pattern part 221-2 may not vertically overlap the cavity C. An upper surface of the second pattern part 221-2 may be positioned higher than the upper surface of the first pattern part 221-1. An upper surface of the second pattern part 221-2 may be positioned higher than the first upper surface 211T1 of the first-first insulating layer 211. An upper surface of the second pattern part 221-2 may be positioned on the same plane as the upper surface of the third pattern part 221-3. An upper surface of the second pattern part 221-2 may be positioned on the same plane as the second upper surface 211T2 of the first-first insulating layer 211. A lower surface of the second pattern part 221-2 may be positioned lower than the first upper surface 211T1 of the first-first insulating layer 211. A lower surface of the second pattern part 221-2 may be positioned lower than an upper surface of the first pattern part 221-1. A lower surface of the second pattern part 221-2 may be positioned on the same plane as the lower surface of the first pattern part 221-1. A lower surface of the second pattern part 221-2 may be positioned lower than a lower surface of the third pattern part 221-3. The second pattern part 221-2 may have a plurality of layer structures. For example, the second pattern part 221-2 may have a two-layer structure formed by a two-stage plating process. In this case, when the second pattern part 221-2 is formed by SAP or MSAP process, the fact that the second pattern part 221-2 has a two-layer structure may mean that the electroplating layer excluding the copper foil layer and the chemical copper plating layer used as the seed layer is composed of two layers. In this case, the second pattern part 221-2 may have a second thickness T2 greater than the first thickness T1. In this case, being positioned on the same plane may mean that a height difference therebetween is 1 µm or less, 0.5 µm or less, or 0.1 µm or less. Alternatively, being positioned on the same plane may mean that a height difference therebetween is 5% or less, 3% or less, or 1% or less of a thickness of the first pattern part 221-1, the second pattern part 221-3, or the third pattern part 221-3.

The third pattern part 221-3 may be formed in a boundary region between the first region RB1 and the second region RB2. Accordingly, a part of the third pattern part 221-3 may vertically overlap the cavity C, and otherwise, may not vertically overlap the cavity C. Preferably, at least a part of the third pattern part 221-3 may vertically overlap at least a part of the inner wall IW of the cavity C.

The upper surface of the third pattern part 221-3 may be positioned higher than the upper surface of the first pattern part 221-1. The upper surface of the third pattern part 221-3 may be positioned higher than the first upper surface 211T1 of the first-first insulating layer 211. The upper surface of the third pattern part 221-3 may be positioned on the same plane as the upper surface of the second pattern part 221-2. The upper surface of the third pattern part 221-3 may be positioned on the same plane as the second upper surface 211T2 of the first-first insulating layer 211. A lower surface of the third pattern part 221-3 may be positioned on the same plane as the upper surface of the first-first insulating layer 211 or the upper surface of the first pattern part 221-1. The lower surface of the third pattern part 221-3 may be positioned higher than the lower surface of the first pattern part 221-1 and the lower surface of the second pattern part 221-2. The third pattern part 221-3 may have a third thickness T3 less than the second thickness T2 of the second pattern part 221-2. In this case, being positioned on the same plane may mean that the height difference therebetween is 1 µm or less, 0.5 µm or less, or 0.1 µm or less. Alternatively, being positioned on the same plane may mean that the height difference therebetween is 5% or less, 3% or less, or 1% or less of the thickness of the first pattern part 221-1, the second pattern part 221-3, or the third pattern part 221-3.

The first thickness T1 of the first pattern part 221-1 may be determined based on the second thickness T2 of the second pattern part 221-2.

That is, the second thickness T2 of the second pattern part 221-2 may correspond to thicknesses of other pattern layers except for the first pattern part 221-1 and the third pattern part 221-3, in the circuit board according the embodiment. At this time, corresponding to the thickness may mean that the difference between the second thickness T2 of the second pattern part 221-2 and the thickness of other pattern layers is 10% or less, 5% or less, 3% or less, or 1% or less of the thickness of the other pattern layers.

For example, the second thickness T2 of the second pattern part 221-2 may satisfy a range of 5 µm to 50 µm. For example, the second thickness T2 of the second pattern part 221-2 may satisfy a range of 10 µm to 40 µm. For example, the second thickness T2 of the second pattern part 221-2 may have a thickness in a range of 15 µm to 30 µm.

In addition, a sum (T1+T3) of a first thickness T1 of the first pattern part 221-1 and the third thickness T3 of the third pattern part 221-3 of the first embodiment may correspond to the second thickness T2 of the second pattern part 221-2.

That is, in an embodiment, the first pattern layer 221 includes a first metal layer and a second metal layer through the two-stage plating process. The first metal layer formed in the two-stage plating process may be used as the first pattern part 221-1 and the third pattern part 221-3, and the second metal layer may be used as the second pattern part 221-2 and the third pattern part 221-3.

Accordingly, the first pattern part 221-1 of an embodiment may include only the first metal layer, and the third pattern part 221-3 may include only the second metal layer. In addition, the second pattern part 221-2 may include both the first metal layer 221-21 and the second metal layer 221-22. Accordingly, the first metal layer 221-21 of the second pattern part 221-2 may have a first thickness T1 corresponding to the first pattern part 221-1. In this case, being able to correspond to the thickness may mean that a difference between the thickness of the first metal layer 221-21 of the second pattern part 221-2 and the first thickness T1 is 10% or less, 5% or less, 3% or less, or 1% or less of the first thickness T1. The second metal layer 221-22 of the second pattern part 221-2 may have a third thickness T3 corresponding to the third pattern part 221-3. In this case, being able to correspond to the thickness may mean that a difference between the thickness of the second metal layer 221-22 and the third thickness T3 is 10% or less, 5% or less, 3% or less, or 1% or less of the third thickness T3.

As described above, in the embodiment, the first pattern layer 221 is formed by dividing it into two layers, and each of the two layers is used as a mounting pad and a laser stopper layer. Accordingly, an embodiment may have a structure in which the first pattern part 221-1 corresponding to the mounting pad and the third pattern part 221-3 corresponding to the stopper layer are disposed on different planes. Accordingly, an embodiment may prevent the first pattern part 221-1 that is a mounting pad from being damaged during a process of forming the cavity C.

The first thickness T1 of the first pattern part 221-1 may satisfy a thickness range of 51% to 85% of the second thickness T2 of the second pattern part 221-2. The first thickness T1 of the first pattern part 221-1 may satisfy a range of 53% to 83% of the second thickness T2 of the second pattern part 221-2. For example, the first thickness T1 of the first pattern part 221-1 may satisfy a range of 55% to 80% of the second thickness T2 of the second pattern part 221-2.

If the first thickness T1 of the first pattern part 221-1 is less than 51% of the second thickness T2 of the second pattern part 221-2, the third thickness T3 of the third pattern part 221-3 may increase correspondingly. And, if the third thickness T3 of the third pattern part 22first-third increases, after the formation of the cavity C is completed, a time required to remove the third pattern part 221-3 by etching may increase, and thus processability may be deteriorated. In addition, if the third thickness T3 of the third pattern part 22first-third increases, a part of the third pattern part 22first-third in a region vertically overlapping the cavity C may not be removed in the etching process, thereby causing a reliability problem such as a short circuit as the first pattern part 221-1 is electrically connected to the third pattern part 221-3. In addition, if the first thickness T1 of the first pattern part 221-1 is less than 51 % of the second thickness T2 of the second pattern part 221-2, an allowable current of the first pattern part 221-1 may decrease, and accordingly, the communication performance may be deteriorated. Meanwhile, if the first thickness T1 of the first pattern part 221-1 exceeds 85% of the second thickness T2 of the second pattern part 221-2, the third thickness T3 of the third pattern part 221-3 may decrease correspondingly. Accordingly, a problem in which the laser penetrates the third pattern part 221-3 may occur in the laser process of forming the cavity C, and accordingly, the upper surface of the first-first insulating layer 211 may be damaged in the process of forming the cavity C. Preferably, the first thickness T1 of the first pattern part 221-1 may satisfy a range of 2.7 to 42.5 µm. For example, the first thickness T1 of the first pattern part 221-1 may satisfy a range of 5.1 to 33.2 µm. For example, the first thickness T1 of the first pattern part 221-1 may satisfy a range of 7.65 to 25.5 µm.

The third thickness T3 of the third pattern part 221-3 may satisfy a range of 15% to 49% of the second thickness T2 of the second pattern part 221-2. The third thickness T3 of the third pattern part 221-3 may satisfy a range of 17% to 47% of the second thickness T2 of the second pattern part 221-2. For example, the third thickness T3 of the third pattern part 221-3 may satisfy a range of 20% to 45% of the second thickness T2 of the second pattern part 221-2.

If the third thickness T3 of the third pattern part 221-3 is less than 15% of the second thickness T2 of the second pattern part 221-2, a problem in which the laser penetrates the third pattern part 221-3 may occur in the laser process of forming the cavity C, and accordingly, the upper surface of the first-first insulating layer 211 may be damaged in the process of forming the cavity C.

If the third thickness T3 of the third pattern part 221-3 is greater than 49% of the second thickness T2 of the second pattern part 221-2, a time required to remove the third pattern part 221-3 by etching in a region vertically overlapping the cavity C may increase, and accordingly, processability may be deteriorated. Also, if the third thickness T3 of the third pattern part 221-3 is greater than 49% of the second thickness T2 of the second pattern part 221-2, a part of the third pattern part 221-3 in a region vertically overlapping the cavity C may not be removed in the etching process, thereby causing a reliability problem such as a short circuit due to the electrical connection of the first pattern part 221-1 with the third pattern part 221-3. If the third thickness T3 of the third pattern part 221-3 is greater than 49% of the second thickness T2 of the second pattern part 221-2, it may be difficult to perform precise etching in the first and second metal layers of the first pattern layer 221 by a thickness corresponding to the second metal layer. Accordingly, the second metal layer may also be partially etched in the etching process, and thus a communication performance problem may occur due to a decrease in the thickness of the first pattern part 221-1.

Meanwhile, although the thickness T1 of the first pattern part 221-1 is greater than the thickness T3 of the third pattern part 221-3, the thickness of the first pattern part 221-1 may be equal to the thickness of the third pattern part 221-3. For example, the first metal layer 221-21 and the second metal layer 221-22 of the second pattern part 221-2 may have the same thickness. However, the communication performance of the circuit board is improved as the thickness of the first pattern part 221-1 is increased, and accordingly, in an embodiment, the thickness of the first pattern part 221-1 is increased with respect to the thickness of the third pattern part 221-3. Accordingly, the embodiment may reduce the time required in the etching process of the third pattern part 221-3, and maximize communication performance due to an increase in the thickness of the first pattern part 221-1.

As described above, the embodiment allows the first pattern layer 221 to have a two-layer structure including a first metal layer and a second metal layer through two-stage plating in the process of forming the first pattern layer. At this time, the first pattern part, which is a mounting pad, is formed using one of the first metal layer and the second metal layer, a third pattern part, which is a laser stopper, is formed using the other one of the first metal layer and the second metal layer, and a second pattern part is formed using both the first metal layer and the second metal layer. Accordingly, the embodiment may solve the reliability problem that occurs when the mounting pad and the stopper are disposed on the same plane. For example, in a comparative example, a separate protective layer (not shown) is formed on the mounting pad to prevent damage to the mounting pad in a laser process of forming the cavity, and then a process of removing the separate protective layer is performed. In contrast, the embodiment may utilize a part of the third pattern part 221-3 used as the laser stopper as a protection part of the first pattern part 221-1, which is the mounting pad, as the protection part. Accordingly, it is possible to omit a process of forming an additional protective layer for protecting the first pattern part 221-1 while preventing the first pattern part 221-1, which is the mounting pad, from being damaged in the process of forming the cavity.

Meanwhile, although the first pattern part 221-1, the second pattern part 221-2, and the third pattern part 221-3 are entirely embedded in the first insulating layer (more clearly, the first-first insulating layer 211), the embodiment is not limited thereto. Specifically, an entire region of each side surface of the first pattern part 221-1, the second pattern part 221-2, and the third pattern part 221-3 is illustrated as being covered by the first insulating layer 211 (more clearly, the first-first insulating layer 211), but the embodiment is not limited thereto.

For example, a partial region of the regions in a thickness direction of each of the first pattern part 221-1, the second pattern part 221-2, and the third pattern part 221-3 may be embedded in the first insulating layer. In addition, among the regions in the thickness direction of the first pattern part 221-1, remaining regions except for the partial region may protrude on the first upper surface 211T1. And, remaining regions except for the partial region in the thickness direction of the second pattern part 221-2 and the third pattern part 221-3 may be embedded in the second insulating layer 311 (more clearly, the second-first insulating layer 311).

However, in the embodiment, in order to secure physical and electrical reliability and physical reliability of the first pattern part 221-1, the second pattern part 221-2, and the third pattern part 221-3, a thickness of each of the partial regions of the first pattern part 221-1, the second pattern part 221-2, and the third pattern part 221-3 are greater than a thickness of the remaining regions. For example, more than 80% of the entire region in the thickness direction of each of the first pattern part 221-1, second pattern part 221-2, and third pattern part 221-3 may be embedded in the first insulating layer. For example, more than 90% of the entire region in the thickness direction of each of the first pattern part 221-1, second pattern part 221-2, and third pattern part 221-3 may be embedded in the first insulating layer. For example, more than 98% of the entire region in the thickness direction of each of the first pattern part 221-1, second pattern part 221-2, and third pattern part 221-3 may be embedded in the first insulating layer.

Meanwhile, pattern layers other than the first pattern layer 221 may have a second thickness T2 corresponding to a thickness of the second pattern part 221-2 of the first pattern layer 221.

Specifically, the second pattern layer 222, the third pattern layer 223, the fourth pattern layer 224, the fifth pattern layer 321, the sixth pattern layer 322, the seventh pattern layer 323, and the eighth pattern layer 324 may have a second thickness T2 equal to the thickness of the second pattern part 221-2 of the first pattern layer 221. In this case, having the same thickness means that the difference from the second thickness T2 is 10% or less, 5% or less, 3% or less, or 1% or less of the second thickness T2.

However, the second pattern layer 222, the third pattern layer 223, the fourth pattern layer 224, the fifth pattern layer 321, the sixth pattern layer 322, the seventh pattern layer 323, and the eighth pattern layer 324 may have a layer structure different from that of the second pattern part 221-2 of the first pattern layer 221. For example, the second pattern part 221-2 of the first pattern layer 221 has the second thickness T2 by a two-stage plating process to distinguish the stopper from the mounting pad. Unlike the second pattern part 221-2 of the first pattern layer 221, the second pattern layer 222, the third pattern layer 223, the fourth pattern layer 224, the fifth pattern layer 322, the sixth pattern layer 322, the seventh pattern layer 323, and the eighth pattern layer 324 may not require layer distinction, and accordingly, may be formed through one plating process. For example, the second pattern layer 222, the third pattern layer 223, the fourth pattern layer 224, the fifth pattern layer 321, the sixth pattern layer 322, the seventh pattern layer 323, and the eighth pattern layer 324 may have a one-layer structure based on an electroplating layer. However, the embodiment is not limited thereto, the second pattern layer 222, the third pattern layer 223, the fourth pattern layer 224, the fifth pattern layer 321, the sixth pattern layer 322, the seventh pattern layer 323, and the eighth pattern layer 324 may also be formed by performing two-stage plating corresponding to the second pattern part 221-2 of the first pattern layer 221, thereby having a two-layer structure based on the electroplating layer.

The first through electrode 231 of the first embodiment may have a fourth thickness T4. For example, the thickness of the first through electrode 231 may be the same as the thickness of the first-first insulating layer 211 in a region vertically overlapping the first circuit layer.

For example, the first through electrode 231 may have a fourth thickness T4 in a range of 10 µm to 60 µm. For example, the first through electrode 231 may have a thickness T4 in a range of 12 µm to 45 µm. For example, the first through electrode 231 may have a thickness of 15 µm to 30 µm.

Meanwhile, one side surface 221-3S1 of the third pattern part 221-3, which horizontally overlaps the cavity C and faces the cavity C, forms the inner wall IW3 of the third part P3 of the cavity C. In this case, as shown in FIG. 3A, one side surface 221-3S1 of the third pattern part 221-3, which is the inner wall IW3 of the third part P3, may have a third slope perpendicular to the reference line BL while being connected to the inner wall IW2 of the second part P2.

Meanwhile, a barrier layer 130 may be disposed on an upper surface of the first pattern part 221-1 exposed through the cavity C. The barrier layer 130 may have a plurality of layer structures.

For example, the barrier layer 130 may include a first layer 131, a second layer 132, and a third layer 133.

The first layer 131 may include nickel. The first layer 131 may be disposed on an upper surface of the first pattern part 221-1. In this case, the first layer 131 may be formed by electroless-plating a metal containing nickel on the upper surface of the first pattern part 221-1. Accordingly, at least a portion of the lower surface of the first layer 131 may not be in contact with the first pattern part 221-1. For example, at least a portion of the first layer 131 may not overlap the first pattern part 221-1 in a vertical direction. For example, the lower surface of the first layer 131 may include a first portion contacting the upper surface of the first pattern part 221-1 and a second portion extending outwardly from the first portion and contacting the first upper surface 211 T1 of the first-first insulating layer 211. For example, the width of the first layer 131 may be greater than the width of the first pattern part 221-1. Accordingly, the first layer 131 may partially be in contact with the upper surface of the first pattern part 221-1 and the first upper surface 211 T1 of the first-first insulating layer 211.

The first layer 131 may prevent diffusion of metal constituting the first pattern part 221-1. For example, the first layer 131 may prevent diffusion of copper constituting the first pattern part 221-1 to the third layer 133 of the barrier layer 130. The first layer 131 may have a thickness ranging from 0.1 µm to 1 µm. The first layer 131 may have a thickness ranging from 0.2 µm to 0.9 µm. The first layer 131 may have a thickness ranging from 0.3 µm to 0.8 µm. When the thickness of the first layer 131 is less than 0.1 µm, the diffusion prevention effect may be insufficient. When the thickness of the first layer 131 is greater than 1 µm, the overall thickness of the barrier layer 130 may increase.

A second layer 132 may be disposed on the first layer 131. The second layer 132 may include palladium. For example, the second layer 132 may be formed by electroless-plating a metal containing palladium on the first layer 131. The second layer 132 may be formed for reliability in a high-temperature reflow process while improving adhesion to solder. The second layer 132 may have a thickness in the range of 0.01 µm to 0.1 µm. The second layer 132 may have a thickness in a range of 0.02 µm to 0.08 µm. The second layer 132 may have a thickness in a range of 0.02 µm to 0.08 µm. The second layer 132 may have a thickness in a range of 0.03 µm to 0.06 µm.

A third layer 133 may be disposed on the second layer 132. The second layer 132 may include gold. For example, the third layer 133 may be formed by substitution plating a metal containing gold on the second layer 132. The third layer 133 may function to prevent oxidation of the first pattern part 221-1. Also, the third layer 133 may be formed to improve bonding property with solder or wire during chip mounting. Preferably, the third layer 133 may be formed to prevent a change in thickness or shape of the first pattern part 221-1 in a subsequent process after the cavity C is formed in the circuit board manufacturing process of an embodiment. The third layer 133 may have a thickness in a range of 0.01 µm to 0.1 µm. The third layer 133 may have a thickness in a range of 0.02 µm to 0.08 µm. The third layer 133 may have a thickness in a range of 0.03 µm to 0.06 µm.

The barrier layer 130 is disposed on the first pattern part 221-1 of the embodiment as described above. In addition, the barrier layer 130 includes a first layer 131, a second layer 132, and a third layer 133. The barrier layer 130 may function to protect the first pattern part 221-1 in a subsequent process after the cavity C is formed. Accordingly, the embodiment does not need to increase the thickness of the first pattern part 221-1 in consideration of the change in the thickness of the first pattern part 221-1 occurring in the subsequent process. Accordingly, the embodiment may reduce the size of the first pattern part 221-1. Furthermore, the embodiment may reduce the thickness of the first pattern part 221-1, thereby reducing manufacturing costs. In addition, the embodiment may prevent the shape change of the first pattern part 221-1 occurring in the subsequent process. Accordingly, the embodiment may allow the chip to be stably mounted on the first pattern part 221-1. Accordingly, the embodiment may improve the physical and electrical reliability of the circuit board.

As described above, the barrier layer 130 includes a first layer 131, a second layer 132, and a third layer 133. In addition, the barrier layer 130 may not only protect the first pattern part 221-1 from chemical damage, but also protect the first pattern part 221-1 from physical damage. In this case, even if a portion of the third layer 133 and the second layer 132 of the barrier layer 130 is damaged or corroded from the chemical or physical damage, the first pattern part 221-1 may be stably protected through the first layer 131 of the barrier layer 130. For example, the first layer 131 includes nickel. In this case, a reduction potential of the nickel is about -0.25 V. This has a value lower than +0.16 V, which is a reduction potential of copper constituting the first pattern part 221-1. Accordingly, the embodiment allows the first pattern part 221-1 to receive electrons from the first layer 131 according to Galvanic corrosion principles. Accordingly, the embodiment may improve the corrosion resistance of the first pattern part 221-1 compared to a case in which the first layer 131 is not present on the first pattern part 221-1.

Meanwhile,, a slope and shape of one side of the third pattern part 221-3 may vary depending on the etching conditions in the etching process.

For example, as illustrated in FIG. 3B, one side surface 221-3S2 of the third pattern part 221-3 may have a predetermined slope inclined with respect to the reference line. For example, a width of the third pattern part 221-3 may decrease from a lower surface to an upper surface. That is, the third part P3 of the cavity C may have a slope whose width decreases as it approaches the first-first insulating layer 211.

In addition, as shown in FIG. 3C, in an embodiment, the third pattern part 221-3 may include a concave portion 221-3U. This may be achieved by adjusting etching conditions in a process of removing a part of the third pattern part 221-3 vertically overlapping the cavity C by etching after the formation of the cavity C is completed. For example, the side surface of the third pattern part 221-3 may be spaced apart from the lower end of the inner wall IW2 of the second part P2 of the cavity C in a horizontal direction away from the cavity C. Accordingly, the third part P3 of the cavity C may be greater than the width of the lower region of the second part P2 by a region corresponding to the concave portion 221-3U.

A horizontal distance of the concave portion 221-3U may range from 1 µm to 12 µm. The horizontal distance of the concave portion 221-3U may range from 2 µm to 10 µm. The horizontal distance of the concave portion 221-3U may range from 3 µm to 8 µm.

Here, the horizontal distance may mean a horizontal distance from an inner wall of the cavity C adjacent to the concave portion 221-3U to one side surface of the third pattern part 221-3. In this case, the third pattern part 221-3 may include a region whose width changes (e.g., increases or decreases) from the lower surface to the upper surface according to an etching condition. In addition, the horizontal distance may mean any one of a greatest horizontal distance of a greatest concave region, a minimum horizontal distance of a smallest concave region, and an average distance of an entire region.

Meanwhile, the embodiment may allow the third pattern part 221-3 to be removed in the etching process. For example, the embodiment may entirely remove the third pattern part 221-3 in the etching process so that the third pattern part 221-3 does not exist in the concave portion 221-3U.

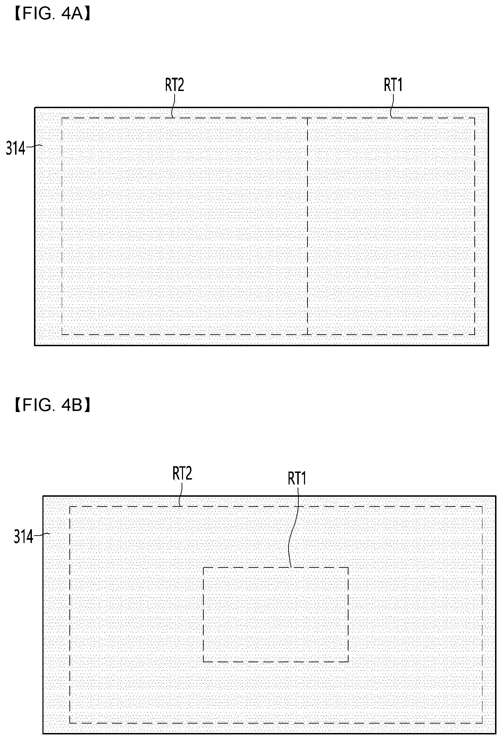

FIGS. 4A and 4B are top plan views of the second substrate layer.

Referring to FIG. 4A, the second substrate layer 300 includes a third region RT1 and a fourth region RT2. In addition, the third region RT1 is a region having a cavity C formed to pass through the second substrate layer 300. In this case, the third region RT1 and the fourth region RT2 may be formed in the width direction or the length direction of the second substrate layer 300, respectively. For example, the third region RT1 may be disposed at one side of the fourth region RT2.

Unlike this, referring to FIG. 4B, the third region RT1 may be disposed at a center of the second substrate layer 300. In addition, the fourth region RT2 may be formed to surround the third region RT1.

Hereinafter, a modified example of a first pattern part of the 1-1 insulating layer 211 and the first pattern layer 221 according to an embodiment and a structure of a barrier layer according to the same will be described.

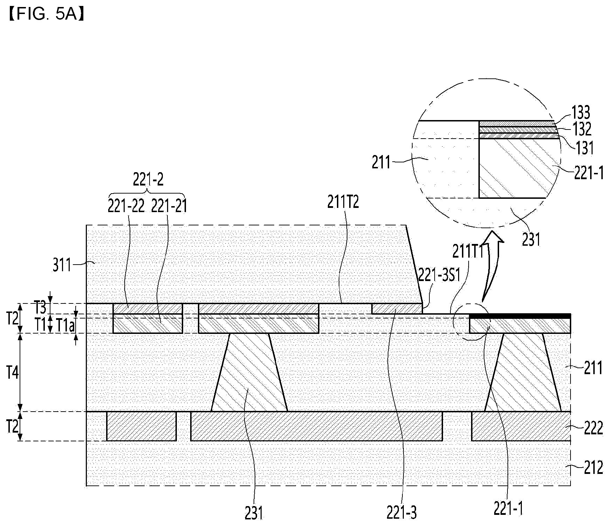

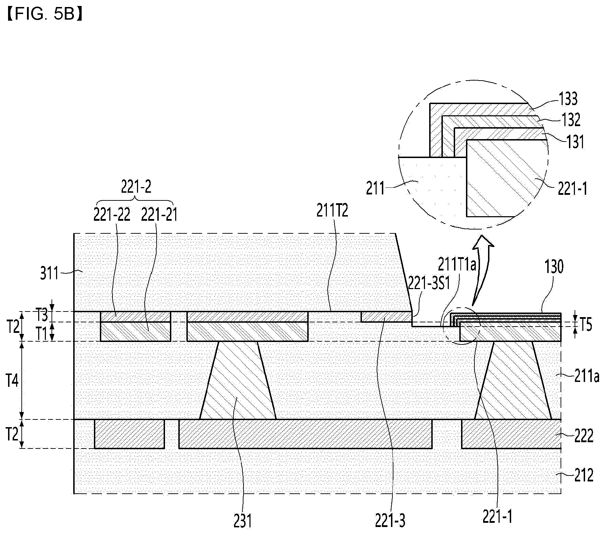

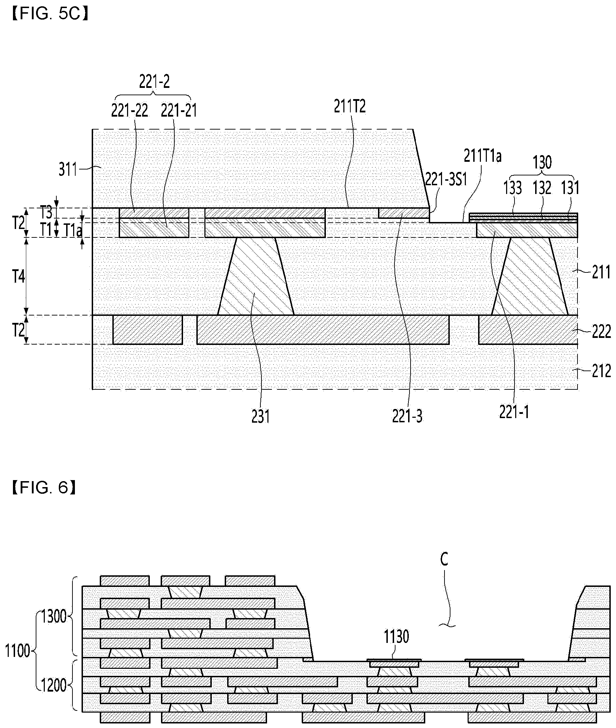

FIG. 5A is a view illustrating a circuit board according to a first modified example, FIG. 5B is a view illustrating a circuit board according to a second modified example, and FIG. 5C is a view illustrating a circuit board according to a third modified example.

Before describing the first to third modified examples, a manufacturing process of the first pattern part 221-1 and the third pattern part 221-3 of the first pattern layer 221 of the embodiment will be briefly described.

Before the cavity C is formed, the third pattern part 221-3 is disposed on the first pattern part 221-1 as a whole in the first region RB1 and the boundary region vertically overlapping the cavity C.

Furthermore, the first region RB1 vertically overlapping the cavity C of an entire region of the third pattern part 221-3 may be etched after the cavity C that proceeds through a laser process is formed. In this case, under an ideal process condition, only the third pattern part 221-3 disposed on the first pattern part 221-1 may be selectively removed. Accordingly, the first pattern part 221-1 and the third pattern part 221-3 may have a positional relationship and a thickness relationship as illustrated in FIG. 3A.

In this case, in the embodiment, the etching process of removing the third pattern part 221-3 may be etched under conditions more than the thickness of the third pattern part 221-3 according to etching conditions.

As illustrated in FIG. 5A, the first pattern part 221-1 may have a first' thickness T1a less than the first thickness T1 of FIG. 3A. That is, the embodiment allows a part of the first pattern part 221-1 to be etched together in the process of etching the third pattern part 221-3. Accordingly, the first pattern part 221-1 may have the first' thickness T1a.

Accordingly, the upper surface of the first pattern part 221-1 may be positioned lower than the first upper surface 211T1 of the first-first insulating layer 211. Also, the upper surface of the first pattern part 221-1 may be positioned lower than the lower surface of the third pattern part 221-3. Also, the upper surface of the first pattern part 221-1 may be positioned lower than the upper surface of the first metal layer 221-21 of the second pattern part 221-2. For example, the thickness T1 of the first pattern part 22first-first in FIG. 3A corresponds to the thickness of the first metal layer 221-21 of the second pattern part 221-2. Alternatively, in the first modified example, the first' thickness T1a of the first pattern part 221-1 may be smaller than the thickness T1 of the first metal layer 221-21 of the second pattern part 221-2.

Meanwhile, the third pattern part 221-3 before the etching process is formed in the entire first region RB1 vertically overlapping the cavity C. In this case, when the etching of the region vertically overlapping the first region RB1 among the entire regions of the third pattern part 221-3 is not performed as a whole, a part of the third pattern part 221-3 may remain on the first region RB1. If there is a part of the remaining third pattern part 221-3, an electrical short problem may occur due to connection between a plurality of first pattern parts 221-1 by the remaining part. Accordingly, in order to solve the problem that a part of the third pattern part 221-3 remains on the first region RB1, in an embodiment, the etching conditions are adjusted to allow the third pattern part 221-3 on the first region RB1 and the part of the first pattern part 221-1 to be etched together. Accordingly, an embodiment may solve an electrical reliability problem due to the remaining part of the third pattern part 221-3, thereby improving product reliability.

Also, a step difference is provided between the upper surface of the first pattern part 22first-first in the first modified example and the first upper surface 211T1 of the first-first insulating layer 211. For example, a recessed portion (not shown) recessed downward with respect to the first upper surface 211T1 of the first-first insulating layer 211 may be provided on the upper surface of the first pattern part 221-1 in the first modified example.

For example, the upper surface of the first pattern part 221-1 may be positioned lower than the first upper surface 211T1 of the first-first insulating layer 211. For example, a recessed portion having a step difference from the first upper surface 211T1 of the first-first insulating layer 211 may be formed at the first pattern part 221-1.

In addition, the barrier layer 130 according to an embodiment may be disposed in the recessed portion. For example, each of the first, second, and third layers 131, 132, and 133 of the barrier layer 130 may be disposed in the recessed portion.

Meanwhile, a vertical distance (e.g., T1-T1a) between a lower surface of the third pattern part 221-3 or the first upper surface 211T1 of the first-first insulating layer 211 and the upper surface of the first pattern part 221-1 may satisfy a range of 2% to 10% of the first thickness T1. A vertical distance (e.g., T1-T1a) between the lower surface of the third pattern part 221-3 or the first upper surface of the first-first insulating layer 211 and the upper surface of the first pattern part 221-1 may satisfy a range of 3% to 9% of the first thickness T1. A vertical distance (e.g., T1-T1a) between the lower surface of the third pattern part 221-3 or the first upper surface 211T1 of the first-first insulating layer 211 and the upper surface of the first pattern part 221-1 may satisfy a range of 3.5% to 8% of the first thickness T1. If the vertical distance (e.g., T1-T1a) between the lower surface of the third pattern part 221-3 or the first upper surface 211T1 of the first-first insulating layer 211 and the upper surface of the first pattern part 221-1 is less than 2% of the first thickness T1, the effect of the dam function may be insufficient due to a small depth of the recessed potion of the first pattern part 221-1. In addition, if the vertical distance (e.g., T1-T1a) between the lower surface of the third pattern part 221-3 or the upper surface of the first-first insulating layer 211 and the upper surface of the first pattern part 221-1 exceeds 10% of the first thickness T1, the allowable current of the first pattern part 221-1 may decrease due to the decrease in the thickness T1a of the first pattern part 221-1, thereby deteriorating communication performance.

Meanwhile, as shown in FIG. 5B, the second modified example may have a difference in height of the first upper surface 211T1a of the first-first insulating layer 211 compared to the circuit board of FIG. 3A.

That is, in the second modified example, after etching the third pattern part 221-3, an additional etching process may be performed on the first region RB1 of the first-first insulating layer 211a. Accordingly, the first upper surface 211T1 of the first-first insulating layer 211a may be positioned lower than the upper surface of the first pattern part 221-1.

That is, the first upper surface 211T1 of the first-first insulating layer 211a may be positioned lower than the lower surface of the third pattern part 221-3. For example, the first upper surface 211T1 of the first-first insulating layer 211a may be positioned lower than the upper surface of the first metal layer 221-21 of the second pattern part 221-2.

That is, unlike the first modified example, the second modified example solves the above residual problem by etching a part of the first upper surface 211T1 of the 1-1 insulating layer 211a vertically overlapping the first region RB1, instead of etching a part of the first pattern part 221-1.

Meanwhile, a vertical distance T5 between the lower surface of the third pattern part 221-3 or the upper surface of the first pattern part 221-1 and the first upper surface 211T1 of the first-first insulating layer 211a may satisfy a range of 2% to 10% of the first thickness T1. For example, a vertical distance T5 between the lower surface of the third pattern part 221-3 or the upper surface of the first pattern part 221-1 and the first upper surface 211T1 of the first-first insulating layer 211a may satisfy a range of 3% to 9% of the first thickness T1. For example, a vertical distance T5 between the lower surface of the third pattern part 221-3 or the upper surface of the first pattern part 221-1 and the first upper surface 211T1 of the first-first insulating layer 211a may satisfy a range of 3.5% to 8% of the first thickness T1.

If the vertical distance T5 between the lower surface of the third pattern part 221-3 or the upper surface of the first pattern part 221-1 and the first upper surface 211T1 of the first-first insulating layer 211a is less than 2% of the first thickness T1, the problem of debris remaining may not be completely solved. Also, If the vertical distance T5 between the lower surface of the third pattern part 221-3 or the upper surface of the first pattern part 22first-first insulating layer 211a exceeds 10% of the first thickness T1, a region (e.g., an exposed region) not covered by the first-first insulating layer 211a increases among the side surfaces of the first pattern part 221-1, which may cause a physical reliability problem with the first pattern part 221-1.

Meanwhile, at least a portion of the side surface of the first pattern part 221-1 in the second modified example is not covered by the first-first insulating layer 211.

Accordingly, the barrier layer 130 may cover at least a portion of the side surface of the first pattern part 221-1. The first layer 131 of the barrier layer 130 may include a first portion disposed on the upper surface of the first pattern part 221-1, and a second portion extended downward from the first portion and disposed on the side surface of the first pattern part 221-1. In addition, the second layer 132 of the barrier layer 130 may be disposed on the first portion and the second portion of the first layer 131. Also, the third layer 133 of the barrier layer 130 may be disposed on the first portion and the second portion of the second layer 132.

Meanwhile, as illustrated in FIG. 5C, the third modified example may apply both the first modified example and the second modified example, and accordingly, the upper surface of the first pattern part 221-1 and the first upper surface 211T1 of the first-first insulating layer 211 may be positioned on the same plane.

Accordingly, the upper surface of the first pattern part 221-1 and the first upper surface 211T1a of the first-first insulating layer 211 may be positioned lower than the lower surface of the third pattern part 221-3, the upper surface of the first metal layer 221-21 of the second pattern part 221-2, and the lower surface of the second metal layer 221-22 of the second pattern part 221-2.

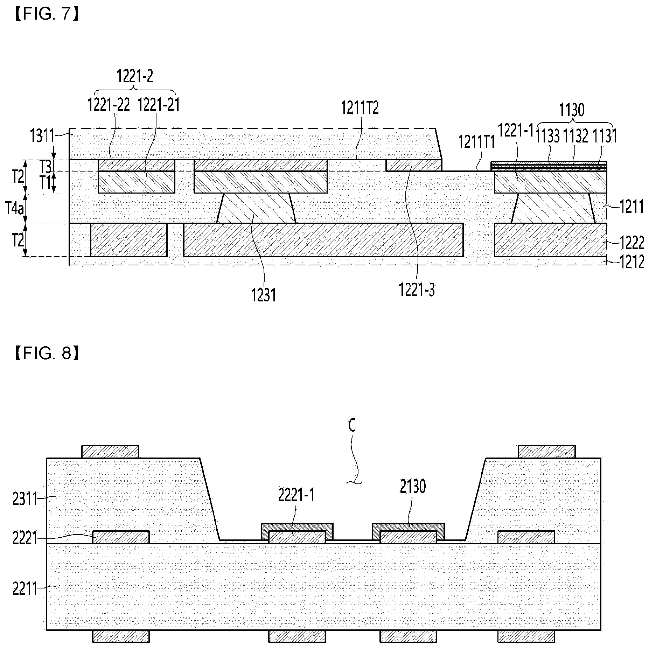

FIG. 6 is a view illustrating a circuit board according to a second embodiment, and FIG. 7 is an enlarged view of a partial region of FIG. 6.

The circuit board according to FIGS. 6 and 7 may correspond to the structure of the circuit board of FIG. 1, and thicknesses of through electrodes of the first substrate layer and the second substrate layer and thicknesses of the first insulating layer and the second insulating layer may be different from that of the circuit board of FIG. 1.

Referring to FIGS. 6 and 7, the circuit board 1100 may include a first substrate layer 1200 and a second substrate layer 1300.

The overall structure of the first substrate layer 1200 and the second substrate layer 1300 is the same as that of the first substrate layer 200 and the second substrate layer 300 of the first embodiment shown in FIG. 1, and a detailed description thereof will be omitted.

Meanwhile, the thickness of the through electrode in the circuit board in FIG. 1 is greater than the thickness of the circuit layer.

Alternatively, the thickness of the through electrode in the circuit board of the second embodiment may be equal to or less than the thickness of the circuit layer.

This can be achieved by reducing the thickness of the insulating layer and thus the thickness of the through electrode while maintaining the thickness of the circuit layer of the circuit board in FIG. 1.

That is, in the embodiment, a cavity C is formed in the second substrate layer, and a chip such as a driving device and a passive device of a driving unit is disposed in the cavity C. Accordingly, the driving unit of the embodiment is disposed in a horizontal direction rather than a vertical direction of the antenna unit. For example, the driving unit is disposed in a direction (e.g., a vertical direction thereof) different from a signal radiation direction of an antenna pattern layer of the antenna unit. Accordingly, the embodiment may not affect communication performance even if the thickness of the insulating layer and the thickness of the through electrode are increased or the distance between the antenna and the driving unit is not sufficiently maintained. Accordingly, an embodiment may reduce the thickness of each insulating layer of the first substrate layer and the second substrate layer, thereby reducing the thickness of the through electrode passing through the insulating layer.

Hereinafter, the first-first insulating layer 1211 and the first through electrode 1231 disposed in the first-first insulating layer 1211 in the first substrate layer 1200 and the second substrate layer 1300 of the second embodiment will be described. However, other insulating layers and through electrodes other than the first-first insulating layer 1211 and the first through electrode 1231 may also have thicknesses to be described below.

The first substrate layer 1200 includes a first-first insulating layer 1211, a first pattern layer 1221, a second pattern layer 1222, and a first through electrode 1231.

The first pattern layer 1221 may include a first pattern part 1221-1, a second pattern part 1221-2, and a third pattern part 1221-3.

The first pattern part 1221-1, the second pattern part 1221-2 and the third pattern part 1221-3 of the first pattern layer 1221 are substantially the same as the first pattern part 221-1, the second pattern part 221-2, and the third pattern part 221-3 described in the first embodiment, and accordingly, a detailed description thereof will be omitted. In addition, the second pattern layer 1222 is substantially the same as the second pattern layer 222 described in the first embodiment, and accordingly, a description thereof will be omitted.

Meanwhile, the first through electrode 1231 is disposed in the first-first insulating layer 1211. The first through electrode 1231 may connect the first pattern layer 1221 and the second pattern layer 1222.

The first through electrode 1231 may have a fourth' thickness T4a smaller than the fourth thickness T4 of the first through electrode 231 of the first embodiment.

For example, the first through electrode 1231 may have the same thickness as at least one of the pattern parts of the first pattern layer 1221 of the first pattern layer 1221.

For example, the first through electrode 1231 may have the same thickness as the first pattern layer 1221 of the first pattern layer 1221. For example, the first through electrode 1231 may have the same thickness as the second pattern part 1221-2 of the first pattern layer 1221.

Preferably, the fourth' thickness T4a of the first through electrode 1231 may be less than or equal to the second thickness T2 of the second pattern part 1221-2 of the first pattern layer 1221. That is, the fourth' thickness T4a of the first through electrode 1231 may be equal to or less than the second thickness T2 of the second pattern part 1221-2.

The fourth' thickness T4a of the first through electrode 1231 may satisfy a range of 51% to 100% of the second thickness T2 of the second pattern part 1221-2. For example, the fourth' thickness T4a of the first through electrode 1231 may satisfy a range of 60% to 95% of the second thickness T2 of the second pattern part 1221-2. The fourth' thickness T4a of the first through electrode 1231 may satisfy a range of 65% to 90% of the second thickness T2 of the second pattern part 1221-2.

If the fourth' thickness T4a of the first through electrode 1231 is less than 51% of the second thickness T2 of the second pattern part 1221-2, a signal interference may occur between the first pattern layer 1221 and the second pattern layer 1222 as a distance between the first pattern layer 1221 and the second pattern layer 1222 becomes too close, and thus a signal transmission loss may increase. If the fourth' thickness T4a of the first through electrode 1231 exceeds 100% of the second thickness T2 of the second pattern part 1221-2, an effect of reducing a thickness of the circuit board according to an embodiment may be insufficient.

As described above, an embodiment may allow the fourth' thickness T4a of the first through electrode 1231 to have the same thickness as that of the first circuit layer or smaller than that of the first circuit layer, thereby reducing the thickness of the circuit board. Also, the thickness of the first through electrode is reduced, and accordingly, an embodiment may reduce a signal transmission distance in a signal transmission path including the first through electrode, thereby minimizing a signal transmission loss.

On the other hand, in the embodiment, a chip is mounted on the cavity C, and accordingly, the thickness of the through electrode disposed in a region adjacent to the cavity C is reduced, thereby minimizing the transmission path of the signal transmitted from the chip or the signal provided to the chip, and thereby minimizing the loss of signal transmission.

Accordingly, the embodiment may allow only the first through electrode 1231 disposed closest to the cavity C among the through electrodes disposed in each insulating layer to have the fourth thickness T4a. In addition, remaining through electrodes other than the first through electrode 1231 (e.g., through electrodes disposed in the second insulating layer, through electrodes disposed in the first-second insulating layer, and through electrodes disposed in the first-third insulating layer) may have a thickness (e.g., T4) greater than the fourth' thickness T4a of the first through electrode 1231. In particular, the through-electrode disposed in the second insulating layer horizontally overlapping the cavity C may transmit or receive a signal through an antenna pattern. In this case, the transmission intensity or reception intensity of a signal through the antenna pattern may increase in proportion to the signal transmission path. Accordingly, in an embodiment, the through electrode disposed in the second insulating layer, the through electrode disposed in the first-second insulating layer, and the through electrode disposed in the first-third insulating layer excluding the first through electrode 1231 may have a fourth thickness T4, and thus communication performance may be maximized.

In addition, the embodiment can increase the number of layers of the circuit layer by reducing the thickness of the insulating layer and through electrode in the circuit board having the same thickness as the comparative example, thereby improving circuit integration and communication performance.

Meanwhile, the first pattern part in FIG. 1 has a structure embedded in the first insulating layer. For example, the side surface of the first pattern part in FIG. 1 is covered with the first insulating layer. In addition, at least a portion of the side surface of the first pattern part in FIG. 5B is covered with the first insulating layer, and at least a remaining portion of the side surface of the first pattern part is not covered with the first insulating layer.

Alternatively, the side surface of the first pattern part is partially covered by an insulating layer, and the insulating layer covering at least a portion of the side surface of the first pattern part may be a second insulating layer, unlike FIG. 5B. In addition, the first pattern part may have a structure protruding from the first insulating layer.

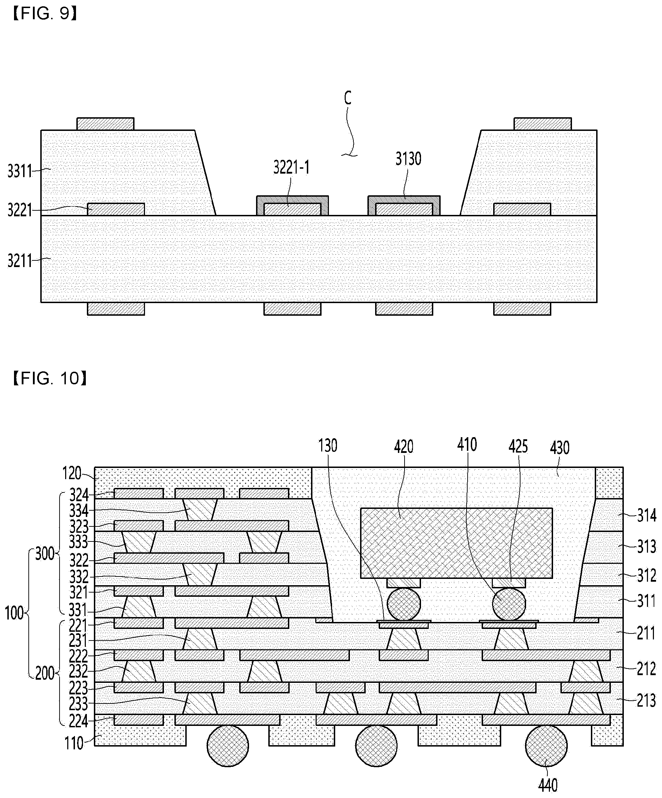

FIG. 8 is a view illustrating a circuit board according to a third embodiment, and FIG. 9 is a view illustrating a circuit board according to a fourth embodiment.

Referring to FIG. 8, the overall structure of the circuit board is the same as that of the previous embodiment.

However, the first pattern layer 2221 may have a structure protruding on the upper surface of the first insulating layer 2211.

In addition, the second insulating layer 2311 may be disposed on the first insulating layer 2211 and may include a cavity C. In this case, a lower surface of the cavity C may be positioned higher than the upper surface of the first insulating layer 2211. For example, at least a portion of the second insulating layer 2311 may cover at least a portion of the side surface of the first pattern part 2221-1 including the upper surface exposed through the cavity C.

Furthermore, the barrier layer 2130 may include a first portion disposed on an upper surface of the first pattern part 2221-1 and a second portion disposed on a side surface of the first pattern part 2221-1, which is not covered by the second insulating layer 2311. For example, the structure of the barrier layer 2130 is the same as that of the barrier layer of FIG. 5B. However, compared to FIG. 5B, at least a part of the side surface of the first pattern part 2221-1 may have a structure covered by a second insulating layer rather than a first insulating layer.

Meanwhile, referring to FIG. 9, the circuit board includes a first insulating layer 3211, a second insulating layer 3311, and a first pattern layer 3221. In addition, the second insulating layer 3311 includes a cavity C. Also, the first pattern layer 3221 includes the first pattern part 3221-1.

At this time, at least a portion of the side surface of the first pattern part 3221-1 of the previous embodiment has a structure covered by the first insulating layer or the second insulating layer.

Alternatively, the side surface of the first pattern part 3221-1 in FIG. 9 may have a structure that is not covered with the first insulating layer and the second insulating layer.

Accordingly, the barrier layer 3130 may include a first portion that entirely covers the upper surface of the first pattern part 3221-1 and a second portion that entirely covers the side surface of the first pattern part 3221-1.

According to the above-described embodiment, the circuit board includes the first pattern part of which the upper surface is exposed through the cavity. In addition, a barrier layer is disposed on the first pattern part. The barrier layer may be composed of a plurality of layers. For example, the barrier layer may include first to third layers. The barrier layer may function to protect the first pattern part in a subsequent process after the cavity is formed. Accordingly, the embodiment does not need to increase a thickness of the first pattern part in consideration of the change in a thickness of the first pattern part occurring in the subsequent process. Accordingly, the embodiment may miniaturize the first pattern part. Furthermore, the embodiment may reduce the manufacturing cost by reducing the thickness of the first pattern part. In addition, the embodiment may prevent a change in a shape of the first pattern part occurring in the subsequent process. Accordingly, the embodiment may allow the chip to be stably mounted on the first pattern part. Accordingly, the embodiment may improve the physical and electrical reliability of the circuit board.

In addition, the circuit board of the embodiment includes a first substrate layer and a second substrate layer. The second substrate layer may include a cavity. The first substrate layer includes a first-first insulating layer disposed closest to the first substrate layer and a first pattern layer disposed on an upper surface of the first-first insulating layer. The first pattern layer includes a first pattern part disposed in a first region vertically overlapping the cavity, a second pattern part disposed in a second region that does not vertically overlap the cavity, and a third pattern part disposed in a boundary region between the first and second regions. A thickness of at least one of the first to third pattern parts is different from a thickness of at least another of the first to third pattern parts. In addition, upper or lower surfaces of at least one of the first to third pattern parts may be positioned on a plane different from upper or lower surfaces of at least another of the first to third pattern parts. The embodiment may allow the first pattern layer disposed in the region adjacent to the cavity to have a structure in which different thicknesses or surfaces are disposed at different positions, thereby improving process characteristics of a process of forming the cavity. Accordingly, the embodiment may solve a reliability problem that may occur during a process of forming a cavity.

Specifically, the embodiment allows the first pattern layer to have a two-layer structure including a first metal layer and a second metal layer through two-stage plating in the process of forming the first pattern layer. At this time, the first pattern part, which is a mounting pad, is formed using one of the first metal layer and the second metal layer, a third pattern part, which is a laser stopper, is formed using the other one of the first metal layer and the second metal layer, and a second pattern part is formed using both the first metal layer and the second metal layer. Accordingly, the embodiment may solve the reliability problem that occurs when the mounting pad and the stopper are disposed on the same plane. For example, in a comparative example, a separate protective layer (not shown) is formed on the mounting pad to prevent damage to the mounting pad in a laser process of forming the cavity, and then a process of removing the separate protective layer is performed. In contrast, the embodiment may utilize a part of the third pattern part used as the laser stopper as a protection part of the first pattern part, which is the mounting pad, as the protection part. Accordingly, it is possible to omit a process of forming an additional protective layer for protecting the first pattern part while preventing the first pattern part, which is the mounting pad, from being damaged in the process of forming the cavity.

In addition, the first substrate layer includes a first region vertically overlapping the cavity and a second region excluding the first region. In addition, the second substrate layer includes a third region corresponding to the cavity and a fourth region excluding the third region. In this case, the third region of the second substrate layer of the embodiment is a region in which a driving device is disposed, and the fourth region is a region in which an antenna pattern layer is disposed. In the above embodiment, an antenna pattern layer is placed in the fourth region of the second substrate layer adjacent to a driving device in a horizontal direction while mounting the driving device using the cavity of the second substrate layer. Accordingly, in an embodiment, a signal transmission distance between the antenna pattern layer and the driving device may be minimized, and thus signal transmission loss may be minimized. For example, the embodiment can reduce the signal transmission distance and reduce the signal transmission loss caused by a separate connection method compared to connecting a substrate where the driving device is disposed and a substrate where the antenna pattern layer is disposed using a separate connection method. In addition, the embodiment may have a structure in which the antenna pattern layer and the driving device are disposed in a horizontal direction, and accordingly, the embodiment may utilize the second region of the first substrate layer, which vertically overlaps the fourth region of the second substrate layer, as a second antenna pattern layer. Accordingly, it is possible to enable antenna pattern radiation and signal reception in different directions using one circuit pattern.

In addition, the embodiment may mount a driving device in the cavity of the second substrate layer, thereby reducing an overall thickness of the circuit board to correspond to a depth of the cavity.

In addition, a cavity of the embodiment includes a first portion having a first slope and a second portion having a second slope different from the first slope. In this case, the second slope has an inclination angle smaller than the first slope with respect to a lower surface of the cavity. In addition, a vertical length of the second portion having the second slope of the embodiment is longer than a vertical length of the first portion having the first slope. Accordingly, the embodiment may reduce a space occupied by the cavity compared to the comparative example, thereby improving circuit integration. For example, the embodiment can increase a length of the antenna pattern layer in a substrate having the same size as the comparative example by reducing the space occupied by the cavity, thereby improving communication performance.

In addition, the embodiment may allow the thickness of the through electrode to have the same thickness as or less than that of the circuit layer. Accordingly, an embodiment may allow the thickness of the through electrode to have the same thickness as that of the circuit layer or less than that of the circuit layer, and accordingly, the thickness of the circuit board may be reduced. In addition, an embodiment may reduce a signal transmission distance in a signal transmission path including the through electrode by reducing the thickness of the through electrode, thereby minimizing the signal transmission loss.

In addition, the embodiment can increase the number of layers of the circuit layer by reducing the thickness of the insulating layer and the through electrode in a structure of the circuit board having the same thickness as the comparative example, thereby improving circuit integration and communication performance.

FIG. 10 is a view illustrating a semiconductor package according to an embodiment.

Referring to FIG. 10, the semiconductor package may include the circuit board 100 illustrated in FIG. 1.

The semiconductor package includes a barrier layer 130 disposed on the first pattern part 221-1 disposed in a region vertically overlapping the cavity C among the first pattern layers 221 of the first substrate layer 200. In addition, a first connection part 410 may be disposed on the barrier layer 130.

A planar shape of the first connection part 410 may be circular. Alternatively, the planar shape of the first connection part 410 may be rectangular. The first connection part 410 may be disposed on the first pattern part 221-1 to connect the first pattern part 221-1 to a terminal 425 of a device 420. The first connection part 410 may be a solder ball. The first connection part 410 may contain a material of a different component in solder. The solder may be composed of at least one of Sn-Cu, Sn-Pb, and Sn-Ag-Cu. And, the material of the different component may contain any one of Al, Sb, Bi, Cu, Ni, In, Pb, Ag, Sn, Zn, Ga, Cd, and Fe.

A device 420 is disposed on the first connection part 410, and the device 420 may be a driver device. For example, the s device 420 may be a driving device for driving an antenna pattern layer included in the circuit board. Also, although only one device is illustrated as being mounted in the cavity C in the drawing, the present invention is not limited thereto. For example, a passive device (not shown) for operating the device 420 in addition to the device 420 may be additionally mounted in the cavity C.

Meanwhile, a molding layer 430 may be formed in the cavity C to cover the device 420. The molding layer 430 may be an epoxy molding compound (EMC), but is not limited thereto.

In addition, the embodiment includes a second connection part 440 disposed on the lower surface of the pattern layer disposed on the lower surface of the first region RB1 of the first substrate layer 200. The second connection part 440 may connect the semiconductor package with an external substrate (e.g., a main board of a terminal).

Hereinafter, a method of manufacturing a circuit board according to an embodiment will be described in order of processes.

In this case, the circuit board of an embodiment may have a coreless structure as illustrated in FIG. 1.

However, the embodiment is not limited thereto. For example, the circuit board of the embodiment may be a core board including a core insulating layer. For example, the circuit board of the embodiment may have an ETS structure manufactured by an embedded trace substrate (ETS) method. However, for convenience of explanation, the embodiment will be described that the circuit board has a coreless substrate structure.

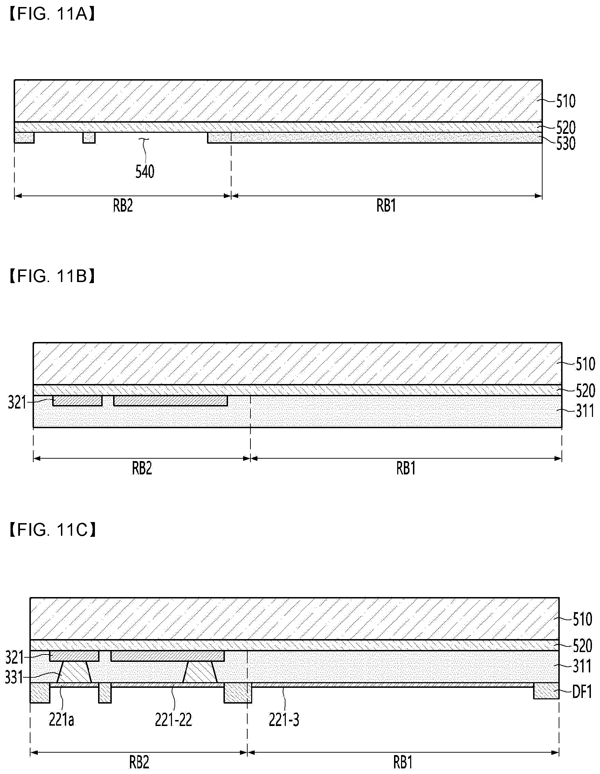

FIGS. 11A to 11Q are views illustrating a method of manufacturing a circuit board according to a first embodiment shown in FIG. 1 in order of processes.

Hereinafter, a method of manufacturing the circuit board according to the first embodiment of FIG. 1 will be described with reference to FIGS. 11A to 11P. However, a circuit board according to another embodiment except for the first embodiment may be manufactured using a process described below.

The manufacturing process of the circuit board of the embodiment of the present application may include a first process of manufacturing a part of the first substrate layer and a part of the second substrate layer using a carrier board, a process of manufacturing the remaining part of the first substrate layer and the remaining part of the second substrate layer above and below the substrate layer manufactured through the first process, respectively, a process of forming a cavity in the second substrate layer, and a process of removing the stopper layer in the region vertically overlapping the cavity.

First, referring to FIG. 11A, a carrier board, which is a basic material for manufacturing a circuit board according to an embodiment, may be prepared.

The carrier board may include a carrier insulating layer 510 and a carrier copper foil layer 520 disposed on one surface of the carrier insulating layer 510.

The carrier copper foil layer 520 may be disposed on one surface of the carrier insulating layer 510, and differently, may be disposed on both surfaces thereof. When the carrier copper foil layers 520 are disposed on both surfaces of the carrier insulating layer 510, a circuit board manufacturing process may be performed on both sides of the carrier board, respectively, until the carrier board is removed.

The carrier copper foil layer 520 may be formed by performing electroless plating on a surface of the carrier insulating layer 510. Alternatively, the carrier insulating layer 510 and the carrier copper foil layer 520 may be a copper clad laminate (CCL).

In this case, the carrier board may be divided into a plurality of regions corresponding to the first region RB1 and the second region RB2 of the first substrate layer 200.

Next, the embodiment may proceed with a process of forming a mask 530 on the lower surface of the carrier copper foil layer 520. In this case, the embodiment may proceed with a process of forming an opening 540 in the mask 530. The opening 540 of the mask 530 may vertically overlap a region in which a fifth pattern layer 321 is to be formed on the lower surface of the carrier copper foil layer 520.

Next, as shown in FIG. 11B, a process of forming a fifth pattern layer 321 filling the opening 540 of the mask 530 may be performed by electroplating the carrier copper foil layer 520 to a seed layer.

Further, in an embodiment, when the fifth pattern layer 321 is formed, a process of removing the mask 530 may be performed. Next, in an embodiment, when the mask 530 is removed, a process of forming a second-first insulating layer 311 that is a part of the second insulating layer of the second substrate layer 300 may be performed on the lower surface of the carrier copper foil layer 520 and the lower surface of the fifth pattern layer 321.

Next, as illustrated in FIG. 11C, an embodiment may proceed with a process of forming a through hole (not shown) penetrating the second-first insulating layer 311. Next, an embodiment may proceed with a process of forming a first dry film DF1 on the lower surface of the second-first insulating layer 311. The first dry film DF1 may include an opening (not shown) vertically overlapping a region in which the first pattern layer 221 is to be formed. Next, an embodiment may proceed with a process of forming a part of the first pattern layer 221 of the first substrate layer 200 and the first through electrode 331 filling the through hole of the second-first insulating layer 311.

Preferably, the first pattern layer 221 is performed through a two-stage plating process. Here, the two-stage plating may mean that the plating process of the electroplating layer excluding the seed layer is performed twice. For example, in a general circuit board manufacturing process, electroplating is performed on the seed layer to form a pattern layer, and accordingly, the electroplating layer of the pattern layer has a one-layer structure. Alternatively, functions of each region of the first pattern layer 221 of the embodiment are different. Accordingly, the embodiment allows the first pattern layer 221 to be formed through two-stage plating in order to form a pattern part suitable for each function, and, accordingly, the electroplating layer of the first pattern layer 221 may have a two-layer structure.

For example, the embodiment may proceed with a process of forming a first electroplating layer 221a filling at least a portion of the opening of the first dry film DF1 on the lower surface of the second-first insulating layer 311. In this case, the first electroplating layer 221a may correspond to the second metal layer 221-22 of the second pattern part 221-2 of the first pattern layer 221 and the third pattern part 221-3.

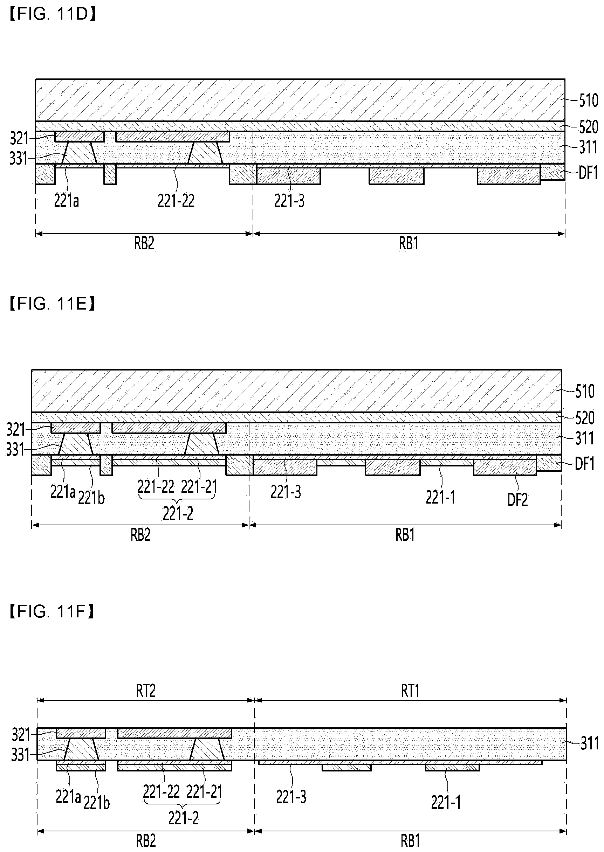

Next, as illustrated in FIG. 11D, the embodiment may proceed with a process of forming the second dry film DF2 on at least a portion of the lower surface of the first electroplating layer 221a. In this case, the second dry film DF2 is formed to cover at least a portion of the first electroplating layer 221a. In other words, the second dry film DF2 includes an opening (not shown) vertically overlapping at least a portion of the lower surface of the first electroplating layer 221a.

Next, as illustrated in FIG. 11E, in the embodiment, secondary electroplating may be performed on the lower surface of the first electrolytic plating layer 221a to form a second electrolytic plating layer 221b filling at least a part of the opening of the second dry film DF2.

In this case, the second electroplating layer 221b may correspond to the first pattern part 221-1 of the first pattern layer 221 and the first metal layer 221-21 of the second pattern part 221-2. Accordingly, a planar area of the first electroplating layer 221a may be different from a planar area of the second electroplating layer 221b. For example, the planar area of the first electroplating layer 221a may be larger than the planar area of the second electroplating layer 221b. In detail, the entire region of the second electroplating layer 221b may vertically overlap the first electroplating layer 221a. However, the first electroplating layer 221a may include an overlapping region vertically overlapping the second electroplating layer 221b and a non-overlapping region not vertically overlapping the second electroplating layer 221b. For example, in an embodiment, the first electroplating layer 221a may function to protect the upper surface of the second electroplating layer 221b corresponding to the first pattern part 221-1 during the laser process while corresponding to a laser stopper. Accordingly, the planar area of the first electroplating layer 221a may be larger than the planar area of the second electroplating layer 221b to correspond to the planar area of the region in which the cavity C is to be formed.

Next, as illustrated in FIG. 11F, the embodiment may proceed with a process of removing the first dry film DF1 and the second dry film DF2. In addition, the embodiment may proceed with a process of removing the carrier insulating layer 510 and the carrier copper foil layer 520.

Thereafter, in the embodiment, a process of manufacturing a part of the second substrate layer 300 and a part of the first substrate layer 200 may be performed on the upper and lower portions of the second-first insulating layer 311, respectively.

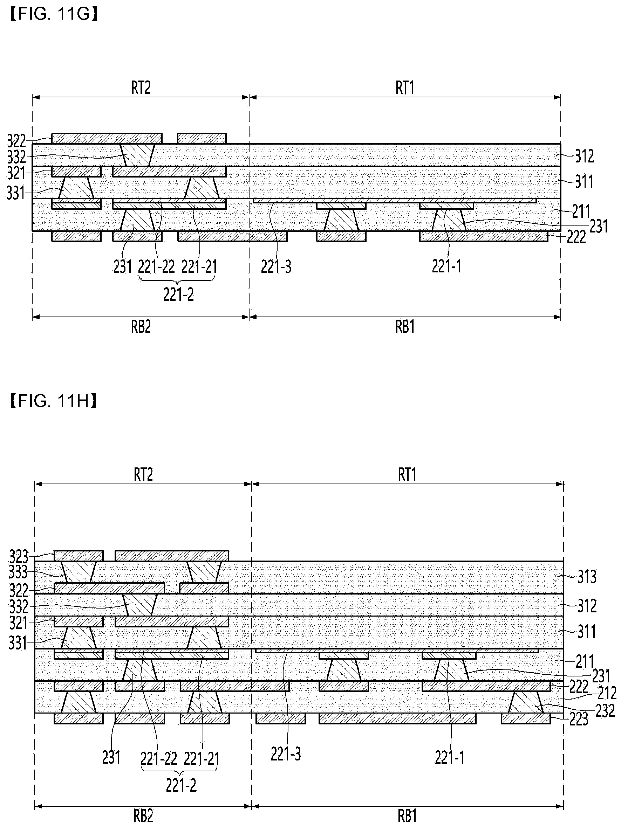

For example, as illustrated in FIG. 11G, an embodiment may proceed with a process of forming a first-first insulating layer 211 on the lower surface of the second-first insulating layer 311, forming a first through electrode 231 penetrating the first-first insulating layer 211, and forming a second pattern layer 222 on the lower surface of the first-first insulating layer 211. Also, an embodiment may proceed with a process of forming a second-second insulating layer 312 on the upper surface of the second-first insulating layer 311, and forming a fifth through electrode 332 penetrating the second-second insulating layer 312 and a sixth pattern layer 322 on the upper surface of the second-second insulating layer 312.

Also, as illustrated in FIG. 11H, an embodiment may perform a process of forming the first-second insulating layer 212 on the lower surface of the first-first insulating layer 211. Also, an embodiment may perform a process of forming the third pattern layer 223 on the lower surface of the first-second insulating layer 212 and the second through electrode 232 penetrating the first-second insulating layer 212.

Furthermore, an embodiment may perform a process of forming a second-third insulating layer 313 on the upper surface of the second-second insulating layer 312. Furthermore, an embodiment may perform a process of forming a sixth through electrode 333 penetrating the second-third insulating layer 313 and a seventh pattern layer 323 on the upper surface of the second-third insulating layer 313.

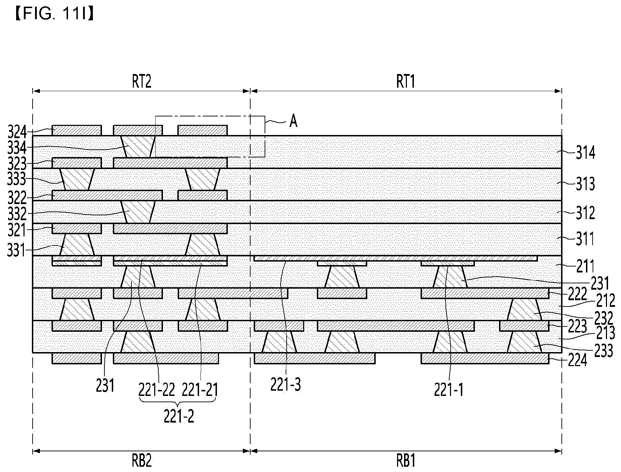

Next, as shown in FIG. 11I, the embodiment may proceed with a process of forming the first-third insulating layer 213 on the lower surface of the first-second insulating layer 212. In addition, the embodiment may proceed with a process of forming a fourth pattern layer 224 on the lower surface of the first-third insulating layer 213 and the third through electrode 233 passing through the first-third insulating layer 213.

In addition, the embodiment may proceed with a process of forming the second-fourth insulating layer 314 on the upper surface of the second-third insulating layer 313. Next, the embodiment may proceed with a process of forming the eighth pattern layer 324 on the second-fourth insulating layer 314 and the seventh through electrode 334 passing through the second-fourth insulating layer 314.

Accordingly, in an embodiment, the manufacture of the circuit board 100 including the first substrate layer 200 and the second substrate layer 300 before the cavity C is formed may be completed.

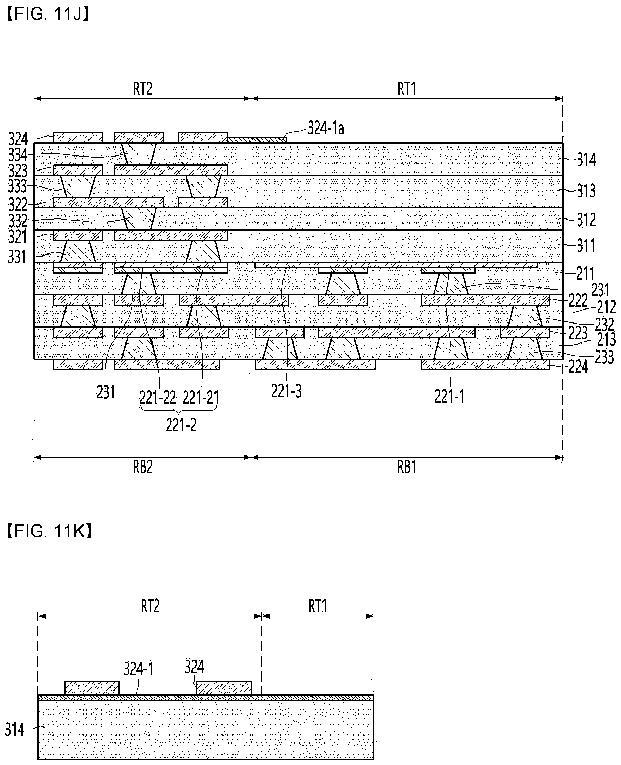

Meanwhile, as shown in FIG. 11J, the embodiment does not remove a part of the seed layer of the eighth pattern layer 324 in the process of forming the eighth pattern layer 324, and uses this to be used as a mask in the process of forming the cavity C.

For example, as shown in FIG. 11K, in a process of manufacturing the eighth pattern layer 324, a seed layer 324-1 for forming the eighth pattern layer 324 by electroplating is positioned on an upper surface of the 2-4th insulating layer 314. In addition, the seed layer 324-1 may be used as a seed layer for electroplating the eighth pattern layer 324.

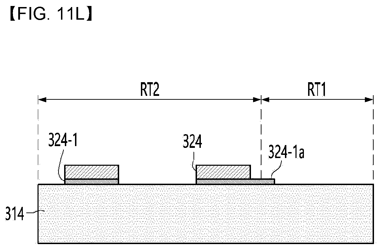

Next, as illustrated in FIG. 11L, when the eighth pattern layer 324 is formed, an embodiment may perform a process of removing a region of the seed layer 324-1 that does not vertically overlap the eighth pattern layer 324. In this case, an embodiment does not remove the region 324-1a adjacent to the region in which the cavity C is to be formed from the seed layer 324-1. When the process of forming the cavity is performed, the embodiment may proceed with a process of forming a cavity only in a portion corresponding to the third region RT1 using the region 324-1a of the seed layer 324-1 as a laser mask. In this case, the region RB1 of the seed layer 324-1 may cover a part of the third region RT1, which is the region in which the cavity C is to be formed. This may be in consideration of the undercut due to the process deviation occurring in the laser forming process.

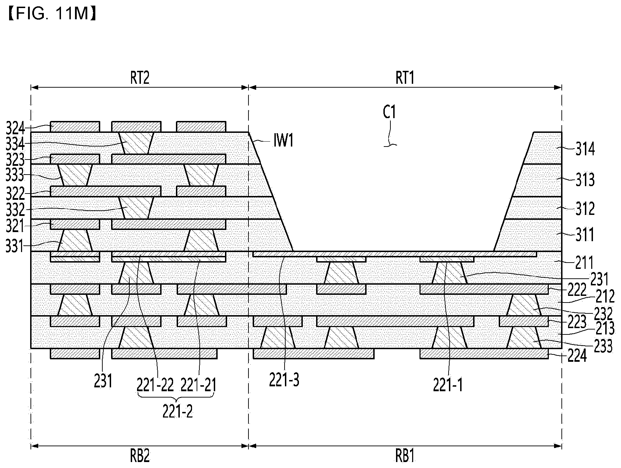

Next, as illustrated in FIG. 11M, the embodiment may proceed with a process of forming a first cavity C1 penetrating the second insulating layers of the second substrate layer 300 by using the region RB1 of the seed layer 324-1. In this case, the first cavity C1 may be formed up to the upper surface (e.g., the upper surface of the third pattern part 221-3) of the first electrolytic plating layer 221a that is a part of the first pattern layer 221 of the first substrate layer 200. In this case, the inner wall IW1 of the first cavity C1 may have a first slope. For example, an embodiment may perform a first cavity process. In this case, a width of the laser mask in the first cavity process may have a first width. The laser mask determines a width of a laser beam in a laser equipment. In this case, in an embodiment, the first cavity process may be performed using a first laser beam having a relatively large width to entirely open a region in which a cavity is to be formed. Accordingly, an inner wall IW1 of the first cavity C1 formed by the first cavity process has a first slope corresponding to the first laser beam as a whole.

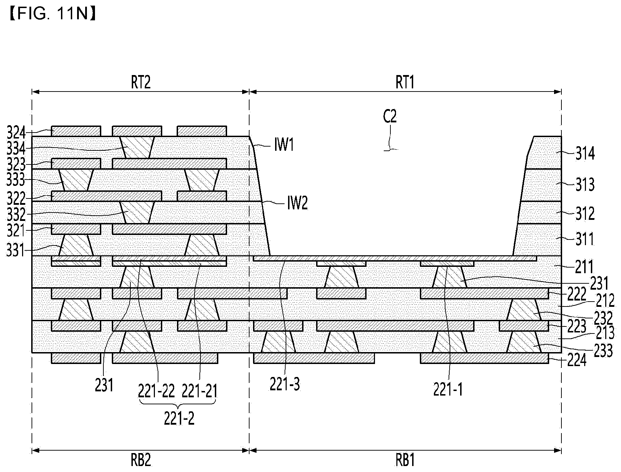

Next, as shown in FIG. 11N, the embodiment may proceed with a process of forming a second cavity C2 by performing a second cavity process on the first cavity C1. In this case, a width of the laser mask in the second cavity process may have a second width smaller than the first width. In addition, the second cavity process may be performed only on a portion corresponding to the inner wall of the first cavity C1 formed in the first cavity process. Since the width of the laser mask in the second cavity process has a second width smaller than the first width, the inner wall of the second cavity C2 may have a plurality of slopes. For example, the inner wall of the second cavity C2 may include a first slope formed by the first cavity process and a second slope formed by the second cavity process.

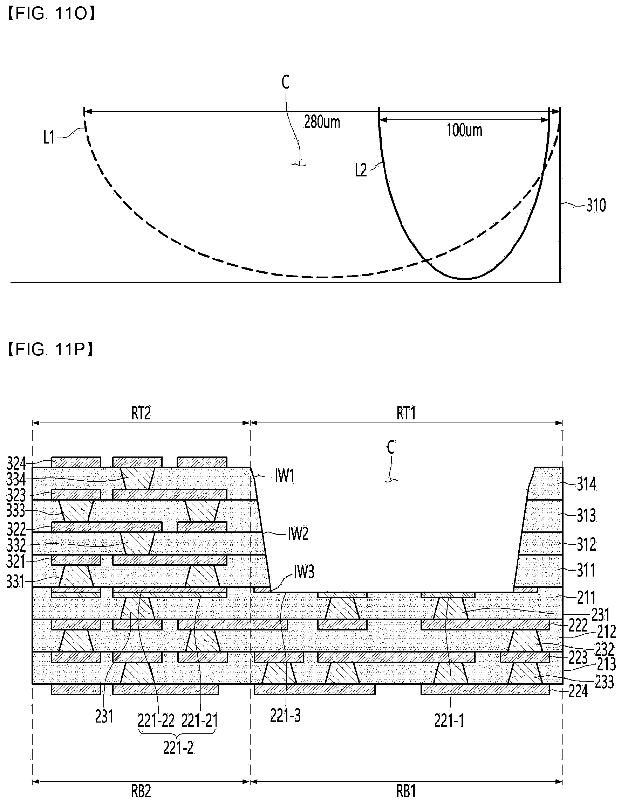

For example, referring to FIG. 11O, an embodiment may proceed with a process of forming the first cavity C1 by irradiating a corresponding first laser beam L1 using a mask having a first width of about 280 µm. Thereafter, an embodiment may proceed with a process of forming the second cavity C2 by irradiating a corresponding second laser beam L2 using a mask having a second width of about 100 µm smaller than the first width. Accordingly, the cavity of the embodiment includes a first slope corresponding to the first laser beam L1 and a second slope corresponding to the second laser beam L2. In this case, the overall slope of the cavity may have the second slope. However, in the first cavity process, the first laser beam L1 penetrates the lower surface of the region RB1 of the seed layer above 324-1, and includes an undercut region accordingly. And, a portion of the cavity C corresponding to the first slope may correspond to an undercut region formed in the first cavity process.

Next, as illustrated in FIG. 11P, the embodiment may proceed with a process of removing a part of the exposed third pattern part 221-3 through the second cavity process. For example, the third pattern part 221-3 may be removed from a region vertically overlapping the cavity C after the process of forming the cavity C is completed. However, the third pattern part 221-3 may have an area larger than an area of the lower region of the cavity C. Accordingly, at least a part of the third pattern part 221-3 may not be removed but may remain in the etching process. For example, the third pattern part 22first-third in the boundary region between the first region RB1 vertically overlapping the cavity C and the second region RB2 other than the first region RB1 may not be removed. In addition, in an embodiment, a third part of the cavity C may be formed by removing a part of the third pattern part 221-3. In this case, the inner wall of the third part may be a side surface of the third pattern part 221-3.

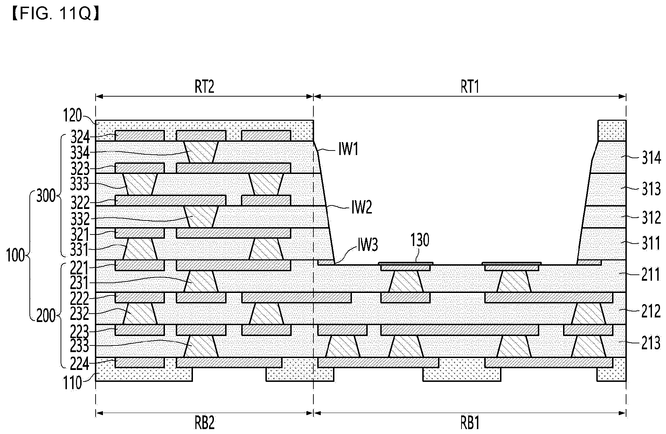

Next, as illustrated in FIG. 11Q, in an embodiment, after the cavity C is formed, a process of forming the barrier layer 130 on the first pattern part 221-1 exposed through the cavity C may be performed. The barrier layer 130 may be formed to cover the exposed surface (e.g., an upper surface and/or at least a portion of a side surface) of the first pattern part 221-1. The barrier layer 130 prevents the thickness or shape change of the first pattern part 221-1 from being changed in a subsequent process after the cavity C is formed. Next, in an embodiment, a process of forming the first protective layer 110 and the second protective layer 120 may be performed.

On the other hand, when the circuit board having the above-described characteristics of the invention is used in an IT device or home appliance such as a smart phone, a server computer, a TV, and the like, functions such as signal transmission or power supply can be stably performed. For example, when the circuit board having the features of the present invention performs a semiconductor package function, it can function to safely protect the semiconductor chip from external moisture or contaminants, or alternatively, it is possible to solve problems of leakage current, electrical short circuit between terminals, and electrical opening of terminals supplied to the semiconductor chip. In addition, when the function of signal transmission is in charge, it is possible to solve the noise problem. Through this, the circuit board having the above-described characteristics of the invention can maintain the stable function of the IT device or home appliance, so that the entire product and the circuit board to which the present invention is applied can achieve functional unity or technical interlocking with each other.

When the circuit board having the characteristics of the invention described above is used in a transport device such as a vehicle, it is possible to solve the problem of distortion of a signal transmitted to the transport device, or alternatively, the safety of the transport device can be further improved by safely protecting the semiconductor chip that controls the transport device from the outside and solving the problem of leakage current or electrical short between terminals or the electrical opening of the terminal supplied to the semiconductor chip. Accordingly, the transportation device and the circuit board to which the present invention is applied can achieve functional integrity or technical interlocking with each other.

The characteristics, structures and effects described in the embodiments above are included in at least one embodiment but are not limited to one embodiment. Furthermore, the characteristics, structures, and effects and the like illustrated in each of the embodiments may be combined or modified even with respect to other embodiments by those of ordinary skill in the art to which the embodiments pertain. Thus, it should be construed that contents related to such a combination and such a modification are included in the scope of the embodiment.

The above description has been focused on the embodiment, but it is merely illustrative and does not limit the embodiment. A person skilled in the art to which the embodiment pertains may appreciate that various modifications and applications not illustrated above are possible without departing from the essential features of the embodiment. For example, each component particularly represented in the embodiment may be modified and implemented. In addition, it should be construed that differences related to such changes and applications are included in the scope of the embodiment defined in the appended claims.

## Claims

1. A circuit board comprising:
a first insulating layer;
a first pattern layer disposed on an upper surface of the first insulating layer;
a second insulating layer disposed on the upper surface of the first insulating layer and including a cavity; and
a barrier layer disposed on a first pattern layer vertically overlapping with the cavity among the first pattern layers,
wherein the upper surface of the first insulating layer includes:
a first upper surface vertically overlapping a lower surface of the cavity, and
a second upper surface that does not vertically overlap the lower surface of the cavity,
wherein the first pattern layer includes:
a first pattern part disposed on the first upper surface of the first insulating layer, and
a second pattern part disposed on the second upper surface of the first insulating layer,
wherein an upper surface of the first pattern part is exposed through the cavity without contacting the first and second insulating layers, and
wherein the barrier layer is disposed on the upper surface of the first pattern part.

2. The circuit board of claim 1, wherein the first upper surface of the first insulating layer constitutes the lower surface of the cavity, and
wherein the second upper surface of the first insulating layer has a step difference from the first upper surface,
wherein a thickness of the first pattern part is smaller than a thickness of the second pattern part, and
wherein at least a portion of a side surface of the first pattern part is covered with the first insulating layer.

3. The circuit board of claim 2, wherein the side surface of the first pattern part is entirely covered with the first insulating layer,
wherein the barrier layer includes:
a first portion disposed on an upper surface of the first pattern part, and
a second portion extending from the first portion and disposed on the first upper surface of the first insulating layer.

4. The circuit board of claim 2, wherein a thickness of the first pattern part is smaller than a thickness of the second pattern part,
wherein an upper surface of the first pattern part is positioned lower than an upper surface of the second pattern part, and
wherein a lower surface of the first pattern part is positioned on the same plane as a lower surface of the second pattern part.

5. The circuit board of claim 1, wherein the first pattern layer includes a third pattern part disposed on a boundary region between the first upper surface and the second upper surface of the first insulating layer, and
wherein a thickness of the third pattern part is smaller than a thickness of the second pattern part.

6. The circuit board of claim 5, wherein an upper surface of the first pattern part is not in contact with the second insulating layer,
wherein upper surfaces of the second and third pattern parts are in contact with the second insulating layer,
wherein the upper surface of the third pattern part is positioned higher than the upper surface of the first pattern part, and is positioned on the same plane as the upper surface of the second pattern part,
wherein a lower surface of the third pattern part is positioned higher than a lower surface of the second pattern part and is equal to or higher than the upper surface of the first pattern part.

7. The circuit board of claim 5, wherein the second pattern part includes:
a first metal layer horizontally overlapping the first pattern part; and
a second metal layer disposed on the first metal layer and in contact with the second upper surface of the first insulating layer,
wherein a thickness of the first metal layer of the second pattern part corresponds to a thickness of the first pattern part, and
wherein a thickness of the second metal layer of the second pattern part corresponds to a thickness of the third pattern part.

8. The circuit board of claim 7, wherein the first upper surface of the first insulating layer is positioned lower than the second upper surface, an upper surface of the second pattern part, and an upper surface of the third pattern part.

9. The circuit board of claim 1, wherein the first upper surface of the first insulating layer is positioned lower than an upper surface of the first pattern part,
wherein a side surface of the first pattern part includes:
a first side surface covered by the first insulating layer, and
a second side surface exposed through the cavity without being covered by the first insulating layer,
wherein the barrier layer includes:
a first portion disposed on an upper surface of the first pattern part, and
a second portion disposed on the second side surface of the first pattern part.

10. The circuit board of claim 1, wherein the first upper surface of the first insulating layer is positioned higher than an upper surface of the first pattern part,
wherein the first insulating layer includes a recess portion formed by a step between the first upper surface and the upper surface of the first pattern part, and
wherein the barrier layer is disposed in the recess portion.
